# EUROPÄISCHE PATENTSCHRIFT

(11) **EP 2 577 740 B1**
(45) Veröffentlichungstag und Bekanntmachung des Hinweises auf die Patenterteilung: **14.11.2018**
(21) Anmeldenummer: 10734437.6
(22) Anmeldetag: 28.05.2010
(51) Int. Cl.: H01L 31/05

(54) **VERFAHREN ZUM KONTAKTIEREN UND VERSCHALTEN VON SOLARZELLEN UND DAMIT HERGESTELLTER SOLARZELLENVERBUND**
METHOD FOR CONTACTING AND CONNECTING SOLAR CELLS AND SOLAR CELL COMBINATION PRODUCED BY MEANS OF SAID METHOD
PROCÉDÉ POUR LA MISE EN CONTACT ET LA CONNEXION ÉLECTRIQUES DE CELLULES SOLAIRES, ET ASSEMBLAGE DE CELLULES SOLAIRES FABRIQUÉ SELON CE PROCÉDÉ

(43) Veröffentlichungstag der Anmeldung: 10.04.2013
(73) Patentinhaber: SolarWorld Industries GmbH, 53175 Bonn (DE)
(72) Erfinder: SCHAARSCHMIDT, Matthias, 09212 Limbach-Oberfrohna (DE); RICHTER, Thilo, 09212 Limbach-Oberfrohna (DE); ENGER, Wolfgang, 09117 Chemnitz (DE); SEIDEL, Thomas, 09232 Hartmannsdorf (DE); GRUNOW, Paul, 10405 Berlin (DE); KUTZER, Martin, 09322 Penig (DE); STORBECK, Olaf, 01109 Dresden (DE); NEUHAUS, Holger, 09599 Freiberg (DE); GEORGI, Matthias, 01307 Dresden (DE)
(74) Vertreter: Rumrich, Gabriele
(86) Internationale Anmeldenummer: PCT/DE2010/075044
(87) Internationale Veröffentlichungsnummer: WO 2011/147388

(56) Entgegenhaltungen:
- EP-A2- 0 115 803
- FR-A1- 2 838 239

## Beschreibung

Die Erfindung bezieht sich auf ein Verfahren zum Kontaktieren und verschalten von Solarzellen sowie einen damit hergestellten Solarzellenverbund, wobei die Kontaktierung der Solarzellen durch Drahtleiter erfolgt und mehrere Solarzellen durch die Drahtleiter miteinander zu dem Solarzellenverbund kombiniert werden.

Eine Solarzelle besteht üblicherweise aus einem Substrat mit einer Vorder- und einer Rückseite, wobei auf mindestens einer der beiden Seiten eine Kontaktstruktur aufgebracht ist. Typischerweise hat die Kontaktstruktur eine Breite von mindestens 100 µm, während ihre Dicke nur etwa 10 bis 15 µm beträgt. Eine größere Breite der Kontaktstruktur führt zu einer Verminderung des Wirkungsgrads aufgrund der dadurch erhöhten Abschattung, während eine Verringerung der Breite den Nachteil zur Folge hat, dass der Linienwiderstand der Kontaktstruktur erhöht wird. Ferner wird der Strom der einzelnen Kontaktstrukturen in Busbars zusammengeführt, wodurch eine weitere Abschattung der Vorderseitenfläche verursacht wird.
Auf der Rückseite der Solarzelle befindet sich in der Regel eine großflächige Kontaktstruktur die den Strom flächig einsammelt.

Die Verschaltung von Solarzellen geschieht im Allgemeinen durch Kontaktbändchen, die auf die Busbars der Solarzelle gelötete werden. Dabei wird der gesamte Strom durch die Kontaktbändchen geführt. Um die Widerstandsverluste so gering wie möglich zu halten, bedarf es einer gewissen Gesamtquerschnittsfläche dieser Bändchen. Dies hat zur Folge, dass der Verlust durch die Abschattung auf der Vorderseite führt.

Um eine optimales Solarmodul zu kreieren müssen also die Kontaktstruktur der Solarzelle und die Anzahl und Dimension der Kontaktbändchen kombiniert optimiert werden.

Ein Problem ist dabei die Handhabung und die Positionierung der dünnen Drähte auf der Solarzelle. Besonders die Reihenschaltung der Zellen macht dabei Probleme, da die Drähte - in Analogie zu den Lötbändchen beim Standardlötprozess - von der Vorderseite der ersten Solarzelle auf die Rückseite der zweiten Solarzellen gebracht werden müssen. Dies impliziert ebenfalls, dass für die Kontaktierung von Vorder- und Rückseite das gleiche Material benutzt werden muss. In der Druckschrift FR 2838239 A1 wird die Schaffung einer Dichtung aus einem anorganischen Material zwischen zwei Glassubstraten, zwischen denen Solarzellen eingekapselt sind und abgedichtet sind beschrieben. Die Verbindungsleiter zwischen den Solarzellen und dem vorderen und dem hinteren Glassubstrat werden aus einem durchgehenden Leiter hergestellt und durch Laserschneiden getrennt, nach der Herstellung des kompletten Schichtaufbaus.

Aus DE 298 05 805 U1 ist eine Vorrichtung zur Solarzellenverarbeitung bekannt, bei welcher einzelne Solarzellen mit elektrischen Verbindern zu einem String zusammengeschaltet werden. Die Vorrichtung weist dazu eine Verbindungsstreifenaufnahme, einen Lötpastendispenser, der die Lötpaste auf die Verbindungsstreifen aufträgt, wenigstens eine Solarzellenablage als Lötplatz, eine Wendeeinrichtung für die Verbindungsstreifen und eine Transporteinrichtung von der Wendeeinrichtung zur Solarzellenablage zur Ablage der Verbindungsstreifen auf den Solarzellen auf.
Nachteilig bei dieser Lösung ist, dass nur Verbinder in Form von Streifen einsetzbar sind, die zudem gewendet werden müssen. Eine Solarzelle mit mindestens einer auf einem metallischen Träger angeordneten Halbleiterschicht und mit einer Mehrzahl von auf der Halbleiterschicht angeordneten Kontaktbahnen wird in DE 10 2006 041 046 A1 beschrieben. Ein seitlicher Überstand mindestens einer Kontaktbahn ist dabei auf eine Rückseite des Trägers umgebogen und gegenüber dem Träger elektrisch isoliert angeordnet. Nebeneinander angeordnete Solarzellen werden vorzugsweise von Leiterbahnen miteinander verbunden, die eine perforierte Ausbildung aufweisen, um lokale Kontaktierungen durch ein Durchlöten zu ermöglichen. Diese Konstruktion der Solarzelle, die Durchführung des Verfahrens zur Herstellung der Solarzelle sowie die konstruktive Realisierung der Leiterbahn soll in die Verschaltung von einzelnen Solarzellen zu Solarmodulen ermöglichen und die einzelnen Solarzellen beliebig zu verschalten. Der Träger ist dabei als ein metallisches Band ausgebildet, wobei die Kontaktbahnen quer oder längs zu einer Längsrichtung des Trägers angeordnet sind, seitlich über das Trägerband überstehen und so zur Verschaltung genutzt werden können. Weiterhin sind Sammelbahnen quer zur Längsrichtung und quer zu den Kontaktbahnen angeordnet und elektrisch mit den Kontaktbahnen verbunden und die Kontaktbahnen sowie die Sammelbahnen im Bereich der Rückseite des Trägers verklebt. Die Kontaktbahnen oder Sammelbahnen sind in Form von Kupferdraht oder - band ausgebildet. Zur Vermeidung einer elektrischen Verbindung der Kontaktbahn mit dem metallischen Träger sind entlang des Randes Isolierungen angeordnet, die als Kantenisolierung realisiert sind. Insgesamt gestalten sich der Aufbau und die Verbindung einzelner Solarzellen durch die Verwendung von perforierten Leiterbahnen problematisch und die Verwendung der Kantenisolierungen stellt einen erhöhten fertigungstechnischen Aufwand dar.

Ein Drahtsystem zum elektrischen Kontaktieren einer Solarzelle, umfassend einen Drahtleiter, der zwischen einem ersten Kontaktierungsabschnitt und einem von dem ersten Kontaktierungsabschnitt beabstandet angeordneten zweiten Kontaktierungsabschnitt derart alternierend verläuft, dass der Drahtleiter das Drahtsystem mit einer maschenartigen Anordnung ausbildet, die sich mit einer Vielzahl von Maschen entlang einer Erstreckungsrichtung fortsetzt, ist aus DE 10 2007 022 877 A1 bekannt. Der Drahtleiter ist durch zusätzlich zum Drahtleiter vorgesehene Fixiermittel und/oder durch Fixiermittel in Form sich umschlingender Abschnitte des Drahtleiters in der maschenartigen Anordnung fixiert. Der Drahtleiter verläuft als Endlosstrang periodisch alternierend entlang einer Erstreckungsrichtung zwischen einem ersten Kontaktierungsabschnitt und einem zweiten Kontaktierungsabschnitt hin und her. Dabei sind die beiden Kontaktierungsabschnitte gleichmäßig voneinander beabstandete Bereiche des Drahtsystems, die entlang der Erstreckungsrichtung des Drahtsystems verlaufen. Jeweils zwei nebeneinander angeordnete Solarzellen weisen in ihren aneinandergrenzenden Randbereichen einander gegenüberliegend angeordnete Solarzellen-Kontaktierungsabschnitte auf, die durch den maschenartigen Drahtleiter miteinander verbunden sind. Weiterhin ist im Solarzellen-Kontaktierungsabschnitt einer Solarzelle eine elektrisch isolierende Basis-Isolatorschicht vorhanden und im Solarzellen-Kontaktierungsabschnitt der daneben angeordneten Solarzelle eine elektrisch isolierende Emitter-Isolatorschicht vorgesehen, wodurch eine Reihenschaltung erzeugt wird. Die Herstellung der maschenartigen Drahtleiter gestaltet sich dabei relativ aufwendig. Ein entscheidender Nachteil dieser Lösung besteht weiterhin darin, dass der Wirkungsgrad negativ beeinflusst wird, da die Flächen für die Kontaktierung Vorderseite zu Rückseite in zwei Dimensionen benötigt werden.

Die als Vorstufe für die Montage von Modulen hergestellten Strings haben den Nachteil, dass die Zellen einzeln aufgesetzt und mit verzinnten Kupferbandstücken belegt werden, welche sowohl die Zellen überdecken als auch unter die nächste, aufzulegende Zelle reichen. Diese Kupferbänder werden mit verschiedenen Methoden verlötet. Dieses Verfahren erfordert eine Vorbereitung der Zellen mit einem Druckbild als Lötverbindungsstoff sowie als Leiterbahn zum "Einsammeln" der freien Elektronen und Transport zu den Kupferbändern.
Die Strings werden durch Handlingseinrichtungen abgeholt, ausgerichtet und zu Modulen zusammengesetzt. Die zusammengesetzten Strings werden durch Querverbinder zu einem Modul elektrisch verbunden. Die erforderlichen Verbindungen werden in einzelnen Verfahrensstufen nacheinander hergestellt, wodurch sich hohe Fertigungszeiten ergeben.

Aus DE 102 39 845 C1 ist eine Elektrode für zum Kontaktieren einer elektrisch leitfähigen Oberfläche, insbesondere wenigstens einer Oberfläche eines fotovoltaischen Elements, bekannt. Diese besteht aus einem elektrisch isolierenden, optisch transparenten Film, einer auf eine Oberfläche des Films aufgebrachten Kleberschicht und einer ersten Gruppe im Wesentlichen paralleler, elektrisch leitfähiger Drähte, die in die Klebstoffschicht eingebettet sind, aus der Klebstoffschicht mit einem Teil ihrer Oberfläche hervortreten und wenigstens auf der aus der Klebstoffschicht heraustretenden Oberfläche mit einer Schicht aus einer Legierung mit niedrigem Schmelzpunkt überzogen sind, wobei die Drähte der ersten Gruppe mit einer ersten Kontaktleiste elektrisch verbunden sind.
Eine zweite Gruppe im Wesentlichen parallel zueinander verlaufender Drähte ist zwischen dem transparenten Film und den Drähten der ersten Gruppe angeordnet, wobei die Drähte der ersten und zweiten Gruppe zusammen ein Gitter bilden und wobei die Drähte der zweiten Gruppe mit einer zweiten Kontaktleiste elektrisch verbunden sind. Diese konstruktive Ausführung ist durch die Verwendung des Films und des Klebers sehr aufwendig. Bei einer unregelmäßigen Dicke der Kleberschicht treten die Drähte nicht gleichmäßig daraus hervor, bzw. können auch vollständig vom Kleber überdeckt werden, wodurch es zu Fehlstellen kommen kann. Weiterhin bleiben Film und Kleber im Modul, das impliziert relativ hohe Anforderungen an den Kleber und den Film hinsichtlich der Langzeitstabilität und verursacht dadurch relativ hohe Kosten. Außerdem ist die Vorfertigung der Elektroden, aus Draht, optisch transparenten Film und Kleber technologisch anspruchsvoll.

Ein Verfahren zum Verdrahten von Solarzellen unter Verwendung von vorgefertigtem Metallgewebe (z.B. Aluminiumgage), welches mit der Oberfläche der Zelle auf der Vorderseite und Rückseite kontaktiert wird, ist aus JP 59115576 A bekannt. Unter Druck und Temperatureinwirkung wird das Metallgewebe mittels einer Heizeinheit mit jeweils einer Zelle verbunden. Bei dieser Lösung gestaltet sich das Handling relativ aufwendig.

In EP 0 440 869 A1 wird ein Bauelement beschrieben, welches eine photoempfindliche Halbleiterplatte mit Barrierestruktur, beiderseits der Halbleiterplatte angeordnete, elektrisch leitfähige Stromabnehmerkontakt, beiderseits der Halbleiterplatte angeordnete Schutzbeläge und Stromabführungselektroden aufweist. Mindestens die an der Vorderseite der Halbleiterplatte angeordneten elektrisch leitfähigen Stromabnehmerkontakte sind in Form von elektrisch verbundenen und aufeinanderfolgenden Abschnitten ausgeführt, die mit der Oberfläche der Halbleiterplatte in Kontakt bzw. nicht in Kontakt stehen. Dazu sind die Stromabnehmerkontakte aus einem gebogenen Draht ausgeführt. Diese Ausführung ist sehr Aufwendig und es kann leicht zum Verdrücken des dünnen gebogenen Drahtes kommen.

Alle bekannten Montagetechnologien für Solarmodule sind weiterhin bezüglich ihrer möglichen Taktzeit sowie der Verarbeitung dünnerer Zellenmaterialien an Grenzen gestoßen, welchen ein Aneinanderreihen von mehren Maschinen entgegengesetzt wird. Dies wirkt sich generell negativ auf die Herstellungskosten aus.
Die Verbindungsmaterialien decken weiterhin einen unerwünscht großen Teil der nutzbaren Siliziumoberfläche ab und verschlechtern so den Wirkungsgrad der Solarzelle.

Weiterhin ist es üblich, spezielle Metallpasten (meist Silber oder Silberlegierungen), z.B. im Siebdruckverfahren in Form von Leiterbahnen auf die Solarzellen aufzubringen (sogenannte Bars) um die Kontaktierung mit den Drahtleitern zu gewährleisten. Dies verteuert die Solarzellen zusätzlich.

Die Aufgabe der Erfindung besteht in der Schaffung eines Verfahrens zum Kontaktieren und Verschalten von Solarzellen sowie damit hergestellte Solarzellenverbunde, wobei die Kosten minimiert und der Wirkungsgrad der Solarzellen verbessert wird. Ein weiteres Ziel der Aufgabe besteht darin, die gedruckten Bereiche für die Bars (Leiterbahnen) zu verringern oder auf diese ganz zu verzichten.

Die Aufgabe wird mit den Merkmalen des ersten und sechsten Patentanspruchs gelöst. Weitere vorteilhafte Ausgestaltungen ergeben sich aus den Unteransprüchen.
Das Verfahren zum Kontaktieren und Verschalten von Solarzellen erfolgt erfindungsgemäß mittels mindestens zweier unabhängiger Elektroden, wobei mindestens eine Elektrode aus wenigstens einem oder einer Vielzahl von zueinander im Wesentlichen parallelen Drahtleitern gebildet wird und nach der Kontaktierung zwischen Solarzellen und Elektroden die Erzeugung einer Reihenschaltung oder Parallelschaltung durch Trennung der dazu erforderlichen Drahtleiter an den erforderlichen Positionen und durch Herstellung einer Verbindung zwischen den Elektroden erfolgt, wobei das Herstellen der Verbindung zwischen den Elektroden vor oder nach dem Trennen realisiert wird.

Es ist somit möglich, die Elektroden vor oder nach dem Trennen direkt oder durch Kontaktelemente/Querverbinder miteinander zu verschalten bzw. zu kontaktieren.

Verfahrensgemäß erfolgt das Kontaktieren und Verschalten von Solarzellen mittels mindestens zweier unabhängiger Elektroden, wobei mindestens eine Elektrode aus wenigstens einem Drahtleiter gebildet wird mit folgenden Schritten:
- Positionieren eines durchgängigen Drahtleiters, so dass er sich über mehrere Solarzellen erstreckt,
- Unterbrechen der Elektroden an den für das Verschalten erforderlichen Positionen nachdem sich der Drahtleiter über mehrere Solarzellen erstreckt und bevor die Solarzellen unter einer Glasplatte fixiert werden,
- Kontaktieren der Solarzellen und Elektroden, wobei die Elektroden durch Querverbinder miteinander kontaktiert werden, wobei die Anordnung des Querverbinders im Wesentlichen senkrecht zur Ausrichtung der Drahtleiter der ersten Elektrode und im Zwischenraum zwischen zwei benachbarten Solarzellen sowie zwischen erster und zweiter Elektrode ist,
- Kontaktieren der Elektroden mit den Solarzellen und/oder Kontaktieren der mindestens zwei Elektroden untereinander vor dem Unterbrechen der Elektroden.

Durch die Verwendung insbesondere durchgängiger erster Drahtleiter und weiterer (insbesondere durchgängiger) Kontaktelemente, die sich in Montagerichtung geradlinig und/oder quer zur Montagerichtung ebenfalls geradlinig erstrecken und bedarfsweise getrennt werden, wird die Fertigung von Solarzellenverbunden revolutioniert und damit wesentlich effektiver und kostengünstiger gestaltet.

Bevorzugt werden die ersten Drahtleiter auf der Oberseite der Solarzelle/n kontaktiert, wobei dann die weiteren Kontaktelemente in Form von zwei elektrischen Querverbindern ausgebildet sein können, die quer zu den ersten Drahtleitern zwischen benachbarten Solarzellen verlaufen und an die ersten Drahtleiter gelegt und mit diesen verbunden werden. Anschließend werden die ersten Drahtleiter quer zu deren Längserstreckung und parallel zu den elektrischen Querverbindern zwischen benachbarten Solarzellen getrennt, so dass ein streifenartiger Verbund von Solarzellen mit einem überstehenden Bereich erster Kontaktelemente und mit den beiden Querverbindern entsteht. Dieser Bereich wird mit der Unterseite der benachbarten Solarzellen verbunden wird, so dass zumindest ein Querverbinder an der Unterseite der benachbarten Solarzelle/n anliegen und nun mit diesen kontaktiert wird.

Alternativ ist es auch möglich, bevorzugt eine Vielzahl erster Drahtleiter an der Oberseite nebeneinander angeordneter Solarzellen und die Querverbinder an der Unterseite der Solarzellen zu befestigen und zu kontaktieren, wobei die Querverbinder und die ersten Drahtleiter ebenfalls rechtwinklig zueinander verlaufen. Anschließend werden die ersten Drahtleiter quer zu deren Längserstreckung und parallel zu den Querverbindern zwischen benachbarten Solarzelle/n getrennt, so dass ein Streifen aus Solarzellen erzeugt wird, die durch die beiden Querverbinder miteinander verbunden sind und der einen überstehenden Bereich mit ersten Drahtleitern aufweist. Anschließend wird der über die Solarzelle/n überstehende Bereich der ersten Drahtleiter mit den Querverbindern an der Unterseite der benachbarten Solarzellen kontaktiert.

Eine weitere Verfahrensvariante zur Herstellung des Solarzellenverbundes besteht darin, dass die ersten geradlinig verlaufenden Drahtleiter ebenfalls auf der Oberseite insbesondere mehrerer Solarzellen kontaktiert werden und dass weitere Kontaktelemente sowohl in Form von zweiten Drahtleitern und auch in Form von Querverbindern ausgebildet sind, wobei die zweiten Drahtleiter ebenfalls insbesondere geradlinig verlaufen und im Wesentlichen parallel zu den ersten Drahtleitern auf der Unterseite der Solarzellen kontaktiert werden. Die ersten und die zweiten Drahtleiter werden miteinander durch die elektrischen Querverbinder verschaltet, wobei die Querverbinder bevorzugt zwischen den ersten und zweiten Drahtleitern verlaufen.
Es wird anschließend jeweils abwechselnd die Verbindung des ersten Drahtleiters und des zweiten Drahtleiters zum Querverbinder unterbrochen, so dass eine Reihenschaltung entsteht.

Bei einer dritten Herstellungsvariante verlaufen der/die bevorzugt durchgängigen ersten Drahtleiter alternierend zwischen der Oberseite und der Unterseite benachbarter Solarzellen. Die zweiten Kontaktelemente sind in Form eines oder mehrerer vorzugsweise durchgängig verlaufender zweiter Drahtleiter ausgebildet, die im Wesentlichen parallel zu den ersten Drahtleitern verlaufen, wobei die zweiten Drahtleiter alternierend (entgegengesetzt) zu dem/den ersten Drahtleiter/n zwischen der Unterseite und der Oberseite benachbarter Solarzellen verläuft/verlaufen. Anschließend werden die ersten Drahtleiter und die zweiten Drahtleiter vorzugsweise zwischen den Solarzellen alternierend so unterbrochen, dass ebenfalls eine Reihenschaltung entsteht.

Das Unterbrechen des ersten und/oder zweiten Drahtleiters erfolgt entweder mechanisch oder bevorzugt mittels Laser.
Insbesondere werden aneinander gereihte Solarzellen durch eine Vielzahl von in Bezug auf die Längsrichtung nebeneinander angeordneten ersten Drahtleitern und/oder zweiten Drahtleitern und/oder Querverbindern miteinander verbunden, wodurch aus den ersten Drahtleitern und /oder den zweiten Drahtleitern und/oder Querverbindern in Verbindung mit den Solarzellen eine Art Gewebe entsteht.

Vorzugsweise werden die Enden der ersten und/oder zweiten Drahtleiter und/oder der Querverbinder zur Abnahme des Stromes mit elektrischen Sammelverbindem versehen. Nachdem die ersten und zweiten Drahtleiter bzw. die Querverbinder an die Solarzellen angelegt wurden, erfolgt das Herstellen der Kontaktierung (elektrischen Verbindung) durch herkömmliche stoffschlüssige Verbindungstechnologien, z.B. durch Kleben, Löten oder Schweißen.
Dabei ist es erstmalig möglich, dass das Herstellen der Kontaktierung zwischen den Drahtleitern bzw. den Querverbindern und den Solarzellen unter Reduzierung oder Verzicht des Aufdruckens von Bars auf die Solarzelle erfolgt. Da die Bars meist aus Silber bestehen bedeutet dies eine erhebliche Kostenreduzierung der Solarzellenverbunde.

Der Solarzellenverbund wird bevorzugt so gefertigt, dass er in mehrere Strings oder Solarzellenmodule getrennt wird bzw. dass er einen Solarzellenmodul bildet. Somit ist es erstmalig effektiv möglich, einen großen Flächenverbund aus miteinander verbundenen und kontaktierten Solarzellen herzustellen.

Der erfindungsgemäße Solarzellenverbund betrifft einen Solarzellenverbund, bei welchem die Solarzellen mittels mindestens zweier unabhängiger Elektroden miteinander kontaktiert sind, wobei eine erste Elektrode mehrere Solarzellen zuerst überspannt, wobei die erste Elektrode eine Vielzahl von zueinander im Wesentlichen parallelen ersten Drahtleitern aufweist, die mit einer Lichteinfallsseite dieser Solarzellen kontaktiert sind. Eine zweite Elektrode überspannt zuerst mehrere Solarzellen, wobei die zweite Elektrode eine Vielzahl von zueinander im Wesentlichen parallelen zweiten Drahtleitern aufweist, die mit der Rückseite dieser Solarzellen kontaktiert sind und wobei die erste und die zweite Elektrode zwischen zwei Solarzellen durch Querverbinder miteinander kontaktiert sind und die erste und zweite Elektrode an den zur Verschaltung erforderlichen Positionen zwischen den Solarzellen getrennt sind.

Der erfindungsgemäße Solarzellenverbund weist mehrere untereinander verbundene und kontaktierte Solarzellen auf, wobei die Solarzellen mit wenigstens einem in Längsrichtung von aneinandergereihten Solarzellen (durchgängig) verlaufenden ersten Drahtleiter oder einer Gruppe von ersten Drahtleitern und mit wenigstens einem weiteren Kontaktelement oder einer Gruppe von weiteren Kontaktelementen miteinander zu einem Solarzellenverbund verbunden und kontaktiert sind und vor oder nach dem Herstellen der elektrischen Verbindung die ersten Drahtleiter und/oder die weiteren Kontaktelemente (zwischen den Solarzellen) so getrennt sind, dass vorzugsweise eine Reihenschaltung vorhanden ist.

Dabei können in einer ersten Variante mehrere durch das Trennen gebildete streifenartige Solarzellenverbunde wieder miteinander verbunden und kontaktiert sein. Dazu können der/die ersten Drahtleiter jeweils von der Oberseite einer Solarzelle zur Unterseite der benachbarten Solarzellen verläuft/verlaufen. Die weiteren Kontaktelemente sind dann in Form von Querverbindern ausgebildet, die zwischen der Unterseite der Solarzelle und dem ersten Drahtleiter angeordnet und mit der/den Solarzelle/n und dem/den ersten Drahtleiter/n kontaktiert sind.

In einer zweiten Variante sind eine Vielzahl zueinander paralleler erster Drahtleiter ebenfalls jeweils auf der Oberseite der Solarzellen kontaktiert. Die weiteren Kontaktelemente sind in Form von zweiten Drahtleitern und in Form von Querverbindern ausgebildet, wobei die zweiten Drahtleiter im Wesentlichen parallel zu den ersten Drahtleitern an der Unterseite der Solarzellen kontaktiert sind und sich quer zu den ersten und zweiten Drahtleitern wenigstens ein mit diesen vorzugsweise in Reihenschaltung kontaktierter Querverbinder erstreckt.
Zur Gewährleistung der Reihenschaltung sind die ersten und zweiten Drahtleiter abwechselnd zum Querverbinder unterbrochen. Weiterhin ist bei dieser Variante der Querverbinder bevorzugt zwischen den ersten und zweiten Drahtleitern und somit bevorzugt zwischen zwei benachbarten Solarzellen und rechtwinklig zu den ersten und zweiten Drahtleitern angeordnet.

Diese neuartige Kontaktierung und Verschaltung von Solarzellen mittels zweier unabhängiger Elektroden in Form der ersten und der zweiten Drahtleiter, wobei mindestens eine Elektrode aus weitestgehend parallelen dünnen Drähten besteht, ermöglicht die Herstellung einer neuen Generation von Solarzellenmodulen.

Ein besonderes Merkmal ist dabei, dass für Vorder- und Rückseite unterschiedliche Elektrodenmaterialien und Verbindungstechnologien genutzt werden können.

Ein Drahtfeld besteht bevorzugt aus jeweils 10 - 50 (optimal ca. 20) Drähten in nahezu äquidistanter Anordnung mit einer Dicke von 50 - 300 µm. Der Querschnitt der Drähte der ersten Drahtleiter (erste Elektrode) und der Querschnitt der Drähte der zweiten Drahtleiter (zweite Elektrode) kann unterschiedliche sein, z.B. rund, oval, rechteckig, trapezoid, dreieckig u.a. Die Drahtleiter bestehen aus Metall, beispielsweise Cu, AI, Ni, Stahl, und können insbesondere zur Herstellung der Verbindung mit den Solarzellen oder untereinander beschichtet sein, beispielsweise mit Lot (Sn-Pb, Sn-Pb-Ag, Sn-Bi usw.), mit Ni oder auch mit einer elektrisch leitfähigen Klebeschicht.

Nach der Erzeugung eines elektrischen Kontaktes zwischen der ersten Elektrode und der Vorderseite der Solarzelle sowie der zweiten Elektrode mit der Rückseite der Solarzelle wird die Verbindung der beiden Elektroden realisiert. Zur Herstellung des elektrischen Kontaktes können bekannte Löt-, Klebe- oder Bond-Techniken eingesetzt werden. Ein besonderes Merkmal ist, dass für Vorder- und Rückseite erstmalig unterschiedliche Verbindungstechnologien genutzt werden können.
Zur Verbindung von erster Elektrode (erste Drahtleiter) und zweiter Elektrode (zweite Drahtleiter oder Bänder) werden bevorzugt die in Querrichtung zu den Drähten verlaufende Kontaktelemente in Form der Querverbinder genutzt. Die Querverbinder sind elektrisch Leitfähig und können beispielsweise aus einem Metall oder einer Metallverbindung bestehen. Die Verbindung zwischen Elektroden (ersten und zweiten Drahtleitern) und Kontaktelement/Querverbinder, kann durch eine Löt-, Quetsch-, Schweiß- oder Klebeverbindung realisiert werden.
Das Kontaktelement/der Querverbinder ist bevorzugt zwischen den ersten und zweiten Drahtleitern (beiden Elektroden) angeordnet sein (in diesem Fall verläuft er zwischen benachbarten Solarzellen) oder aber über oder unter beiden.

Die Kontaktelemente/Querverbinder können strukturiert sein, so dass später im Modul das von ihnen reflektierte Licht durch Totalreflexion am Glas auf die aktive Zellfläche gelenkt wird.

Weiterhin ist eine Beschichtung der Kontaktelemente derart denkbar, dass keine spiegelnd-glänzende Oberfläche entsteht, sondern eine diffus reflektierende Oberfläche, so dass ebenfalls ein großer Teil des reflektierten Lichtes die aktive Zellfläche erreicht, wodurch der Wirkungsgrad weiter erhöht werden kann.

Zur Herstellung eines derartigen Solarzellenverbundes werden über der Oberseite der Solarzellen die ersten Drahtleiter und unter der Unterseite der Solarzellen die zweiten Drahtleiter angeordnet.
Dazu werden die zweiten Drahtleiter zuerst auf einer Unterlage positioniert, darüber anschließend die Solarzellen und die Querverbinder aufgelegt und anschließend die ersten Drahtleiter auf der Oberseite der Solarzellen abgelegt. Dieser "noch lose Verbund" wird anschließend miteinander verbunden und kontaktiert. Um die bisher noch kurzgeschlossenen Zellen in eine elektrisch sinnvolle Reihenschaltung oder Parallelschaltung zu bringen müssen nun noch die überflüssigen und störenden Drahtbrücken entfernt werden.
Dazu wird wechselseitig jedes zweite Drahtfeld in den Zellzwischenräumen getrennt bzw. herausgeschnitten um alle Verschaltungen identischer Polarität im String zu unterbrechen.

Das Trennen/Ausschneiden kann unter anderem mittels Laser oder einer insbesondere selbstzentrierenden Schneideinrichtung erfolgen, die beim Schneiden keine Kräfte auf die Drähte ausübt um Beschädigungen der Solarzellen zu vermeiden.

Dabei könnte die Schneideinrichtung mittels eines Kamerasystems anhand der Zellkanten justiert werden.

Bei einer dritten Variante der erfindungsgemäßen Lösung verläuft/verlaufen der/die erste/n durchgängige/n Drahtleiter alternierend zwischen der Oberseite und der Unterseite benachbarter Solarzellen. Das/die weitere/n Kontaktelement/e ist/sind in Form eines oder mehrerer zweiter Drahtleiter ausgebildet, die zu den ersten Drahtleitern im Wesentlichen parallel sind, wobei der/die zweiten Drahtleiter alternierend entgegengesetzt zu dem/den ersten Drahtleiter/n zwischen der Unterseite und der Oberseite benachbarter Solarzellen verläuft/verlaufen. Weiterhin sind die ersten und die zweiten Drahtleiter vorzugsweise so zwischen den Solarzellen getrennt, dass eine Reihenschaltung vorhanden ist.
Bevorzugt sind eine Vielzahl von ersten Drahtleitern und eine Vielzahl von weiteren Kontaktelementen vorgesehen, so dass eine Art Gewebe gebildet wird. Dabei führen insbesondere eine Vielzahl von ersten Drahtleitern jeweils über eine Solarzelle und bei Verwendung von zweiten Drahtleitern auch eine Vielzahl dieser über jeweils eine Solarzelle, wodurch eine optimale Elektronenabnahme gewährleistet ist.

Dabei sind in der Draufsicht auf den Solarzellenverbund erste und zweite Drahtleiter abwechselnd angeordnet.

Die ersten Drahtleiter und/oder die zweiten Drahtleiter und/oder die Querverbinder sind bevorzugt in Form eines Drahtes mit im Wesentlichen rundem oder rechteckigem Querschnitt bzw. in Form eines Bandes ausgebildet und weisen insbesondere nur einen sehr geringen Querschnitt auf. Der sehr geringe Querschnitt ist dabei dann möglich, wenn mit einer Solarzelle mehrere erste und/oder zweite Drahtleiter kontaktiert sind.

Weiterhin sind die Enden der ersten und/oder zweiten Drahtleiter und/oder die Enden der Querverbinder zum Abgriff des Stromes mit elektrischen Sammelverbindern versehen.

Die ersten und/oder die zweiten Drahtleiter und/oder die Querverbinder sind mit den Solarzellen insbesondere stoffschlüssig, z.B. durch Kleben, Löten oder Schweißen verbunden.
Die ersten und/oder zweiten Drahtleiter und/oder die Querverbinder können dabei erstmalig auch unter Verzicht des Aufdruckens von Bars (Leiterbahnen) direkt mit der/den Solarzelle/n verbunden sein.

Weiterhin ist es möglich, einen Solarzellenverbund durch Trennung der Drahtleiter bzw. Querverbinder in Segmente zu teilen. Diese können versetzt übereinander gelegt und zu einem Solarzellenmodul oder zu einem Modulverbund verbunden werden.

Die Fertigung kann jedoch auch wie bisher Stringweise geschehen.

Ein erheblicher Vorteil der erfindungsgemäßen Lösung ist die Eignung durch eine Parallelisierung und eine Verwendung von entsprechend breiteren Elektrodenfeldern die Verschaltung und Matrixlegung zu vereinheitlichen, so dass unnötige Zell und String-Handlings vermieden werden können.

Mit der erfindungsgemäßen Lösung können die Fertigungskosten und somit die Kosten der Solarzellenmodule erheblich reduziert werden. Weiterhin ist es möglich, die Aufwendungen für das Equipment bzw. die Anlagenkosten wesentlich zu senken und den Flächenbedarf für die Herstellung der Solarzellen zu reduzieren.
Da es möglich ist, einen Solarzellenverbund aus einer Vielzahl von Solarzellen weitestgehend kontinuierlich bzw. in einer Arbeitsstufe (bei Variante 2) zu bilden, verringert sich die Belastung der Zellen durch Montagestress.
Ein weiterer Vorteil der erfindungsgemäßen Lösung liegt darin begründet, dass der Einsatz von teuren, für das Leiterbahnendrucken erforderlichen, Materialien erheblich reduziert werden kann oder es möglich ist, auf das Drucken von Leiterbahnen ganz zu verzichten, da die Drahtleiter direkt mit den Solarzellen verbunden, insbesondere verlötet oder verklebt werden können.

Weiterhin kann mit der Erfindung der Wirkungsgrad der Solarzellenmodule im Vergleich zu herkömmlichen Lösungen erheblich verbessert werden. Dies ist insbesondere bei der Verwendung einer Vielzahl von Drahtleitern je Solarzelle möglich durch die Reduzierung der abgeschatteten Flächen und durch die erhöhte Reflektion der Seitenbereiche der Drähte sowie durch geringere innere Verluste in der Solarzelle durch nahezu flächige Elektronenabnahme. Weiterhin ist es möglich, Wirkungsgradverluste durch Zellenbruch zu senken.

Die Erfindung wird nachstehend anhand von Ausführungsbeispielen und zugehörigen Zeichnungen näher erläutert.

### Es zeigen:

Figur 1 bis 6 die Verfahrensstufen zur Herstellung einer ersten Variante eines Solarzellenverbundes aus Solarzellen durch die Verwendung erster Drahtleiter und weiterer Kontaktelemente in Form von zu diesen quer verlaufenden Querleitern, dabei ist dargestellt in
- Fig. 1:: Längsschnitt der von hintereinander und nebeneinander angeordneten Solarzellen, auf deren Oberseiten erste Drahtleiter aufgelegt wurden, wobei zwischen zwei hintereinander angeordneten Solarzellen über den ersten Drahtleitern zwei Querleiter aufgelegt sind,
- Fig. 2:: dreidimensionale Ansicht von oben gem. eines Teilbereiches nach Fig. 1,
- Fig. 3:: eine erste Reihe R1 nebeneinander angeordneter Solarzellen, die durch Trennen der ersten Drahtleitern zu den davor angeordneten Solarzellen gebildet wurde,
- Fig. 4:: zwei Reihen R1, R2 von Solarzellen, die miteinander verbunden werden sollen,
- Fig. 5:: Seitenansicht von miteinander kontaktierten Reihen R1 bis R3 von Solarzellen,
- Fig. 6:: dreidimensionale Ansicht eines nach Variante 1 hergestellten Solarzellenverbundes,

Figur 7 bis 10 die Verfahrensstufen zur Herstellung einer zweiten Variante eines Solarzellenverbundes aus Solarzellen durch die Verwendung erster Drahtleiter und weiterer Kontaktelemente in Form von zu diesen quer verlaufenden Querleitern sowie zu den ersten Drahtleitern parallelen zweiten Drahtleitern, die auf der Unterseite der Solarzellen verlaufen, dabei ist dargestellt in

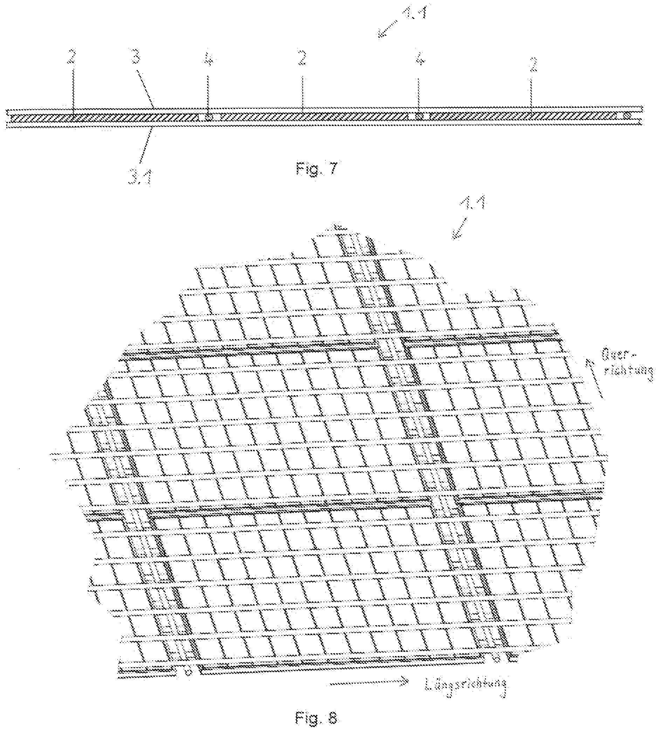

- Fig. 7:: Längsschnitt von hintereinander und nebeneinander angeordneten Solarzellen, wobei erste Drahtleiter über die Oberseiten der hintereinander angeordneten Solarzellen in Längsrichtung verlaufen und an der Unterseite der Solarzellen die zweiten Drahtleiter anliegen und jeweils zwischen den ersten Drahtleitern und den zweiten Drahtleitern die Querleiter verlaufen,
- Fig. 8:: dreidimensionale Ansicht von oben gem. Fig. 7,

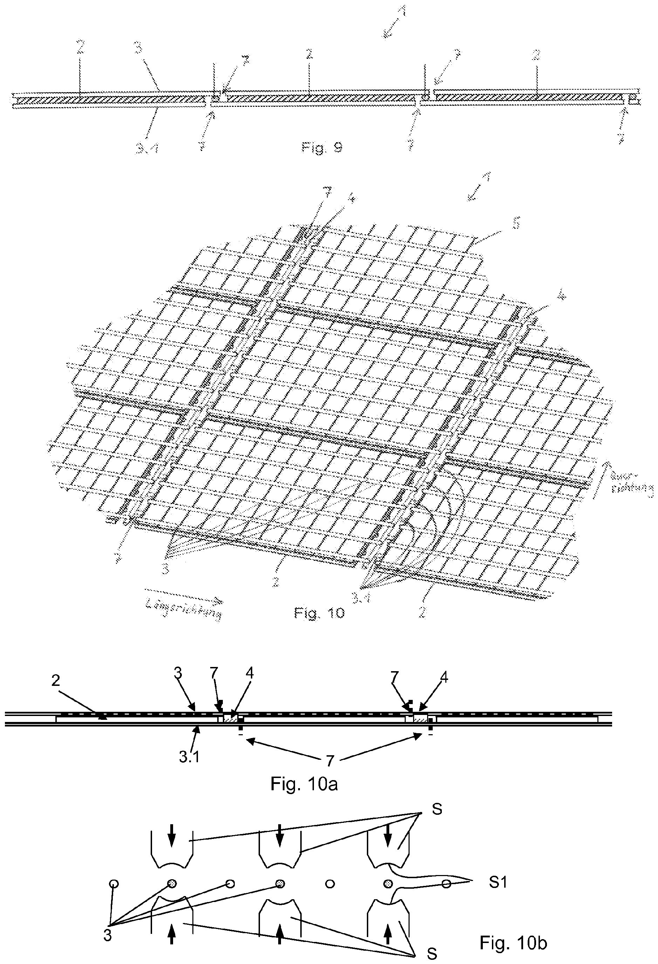

- Fig. 9:: Solarzellenverbund gem. Fig. 7 und 8 im Längsschnitt, bei welchem anschließend abwechselnd die Verbindung zwischen ersten und zweiten Drahtleitern zum Querleiter unterbrochen wurde,

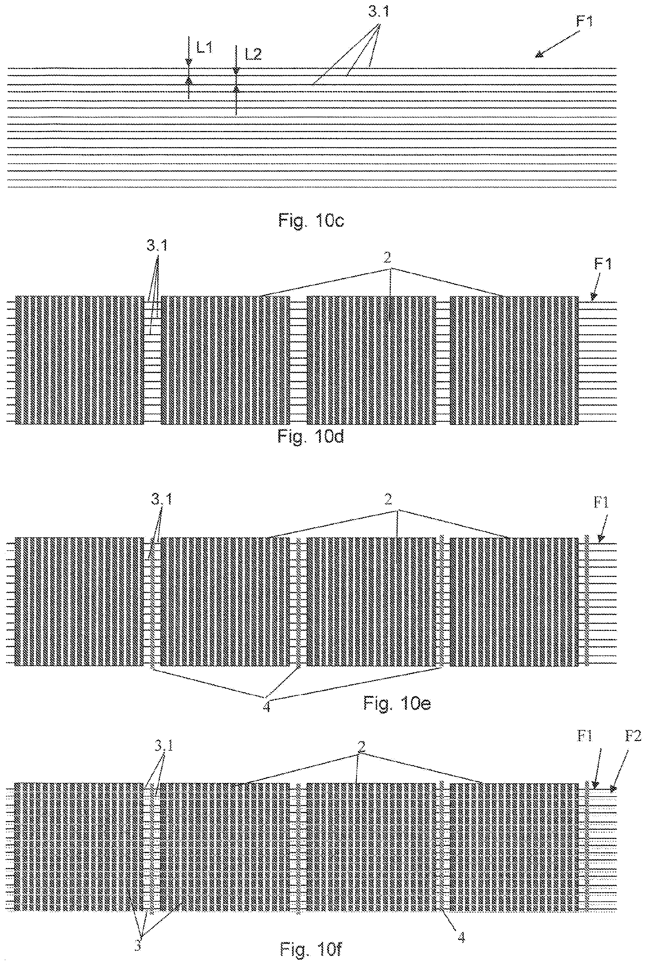

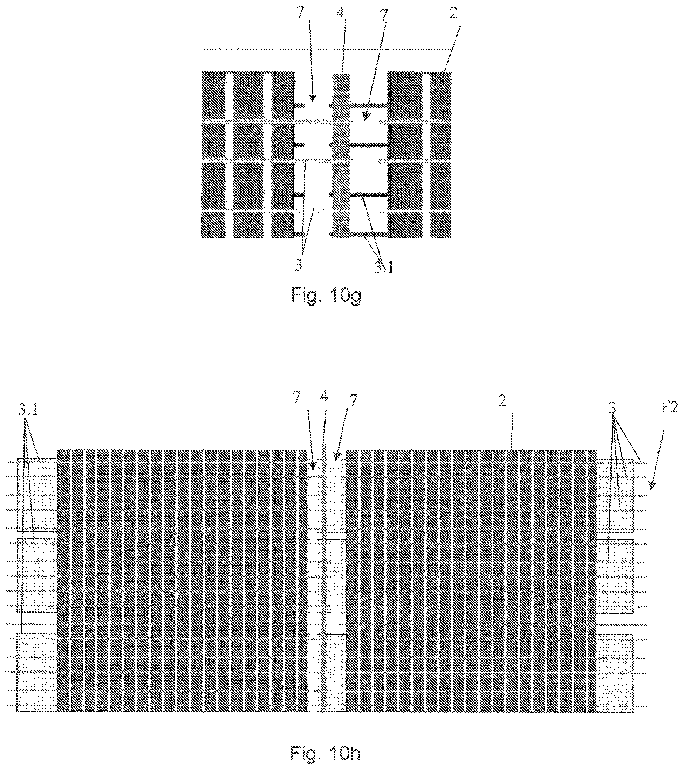

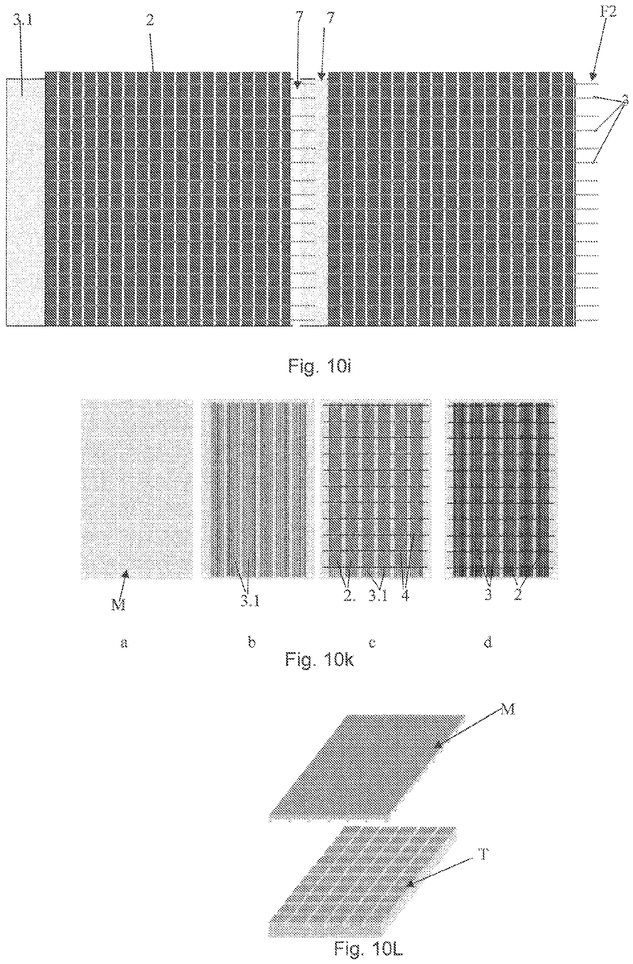

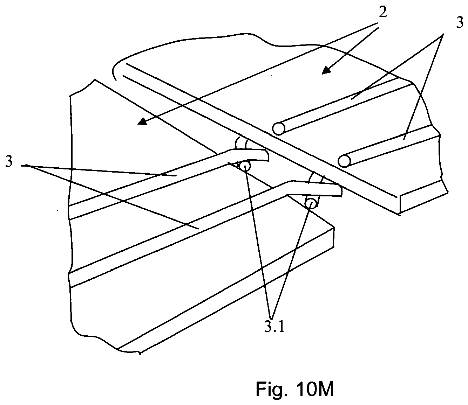

- Fig. 10:: Solarzellenverbund gem. Fig. 9 in dreidimensionaler Ansicht von oben,
- Fig. 10a:: Längsschnitt einer weiteren Variante, ähnlich Fig. 9, jedoch mit unterschiedlichen ersten und zweiten Drahtleitern,
- Fig. 10b:: Prinzipdarstellung der Schneideinrichtung,
- Fig. 10c:: Darstellung eines (unteren) ersten Drahtfeldes F1 aus zweiten Drahtleitern 3.1,
- Fig. 10d:: Darstellung von auf dem ersten Drahtfeld F1 positionierten Solarzellen 2,
- Fig. 10e:: Darstellung gem. Fig. 10d mit Querverbindern 4,
- Fig. 10f:: Darstellung gem. Fig. 10e mit einem zweiten Drahtfeld F2 aus ersten Drahtleitern 3,
- Fig. 10g:: Darstellung der getrennten ersten und zweiten Drahtleiter 3, 3.2,
- Fig. 10h:: Darstellung eines Solarzellenverbundes mit ersten (oberen) Drahtleitern 3 in Form von dünnen Drähten und zweiten (unteren) Drahtleitern 3.1 in Form von breiten Bändern,
- Fig. 10j:: Darstellung eines Solarzellenverbundes mit ersten (oberen) Drahtleitern 3 in Form von dünnen Drähten und zweitem (unteren) Drahtleiter 3.1 in Form einer ganzflächigen Folie,
- Fig. 10k:: die Arbeitsschritte Start mit einem leerem Carrier, Ausziehen der Rückseitendrähte, Platzieren der Zellen, Ausziehen der Querverbinder sowie Ausziehen der Vorderseitendrähte,
- Fig. 10l:: Transport des auf der Matrixplatte M erzeugten Carrier zur Heizplatte T.

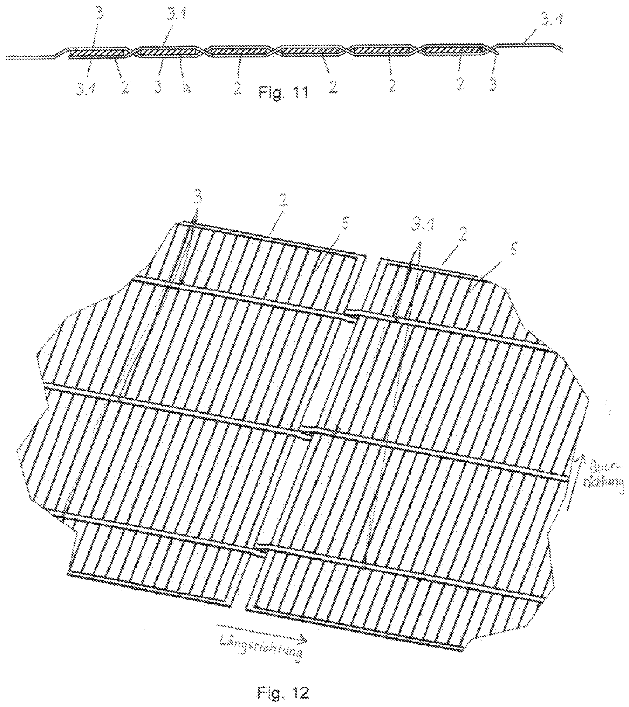

Figur 11 bis 18 die Verfahrensstufen und eine Einrichtung zur Herstellung einer dritten Variante eines Solarzellenverbundes aus Solarzellen durch die Verwendung erster Drahtleiter, die alternierend zwischen der Oberseite und der Unterseite der Solarzellen verlaufen und weiterer Kontaktelemente in Form von zu den ersten Drahtleitern parallelen zweiten Drahtleitern, die umgekehrt alternierend zu den ersten Drahtleitern zwischen den Unterseiten und den Oberseiten der Solarzellen verlaufen, dabei ist dargestellt in
- Fig. 11:: Längsschnitt von hintereinander und nebeneinander angeordneten Solarzellen, wobei der erste Drahtleiter über die Oberseite und die Unterseite der benachbarten Solarzellen läuft und der zweite Drahtleiter dazu umgekehrt zwischen der Unterseite und der Oberseite der benachbarten Solarzellen verläuft,
- Fig. 12:: dreidimensionale Ansicht gem. Fig. 11 von oben,

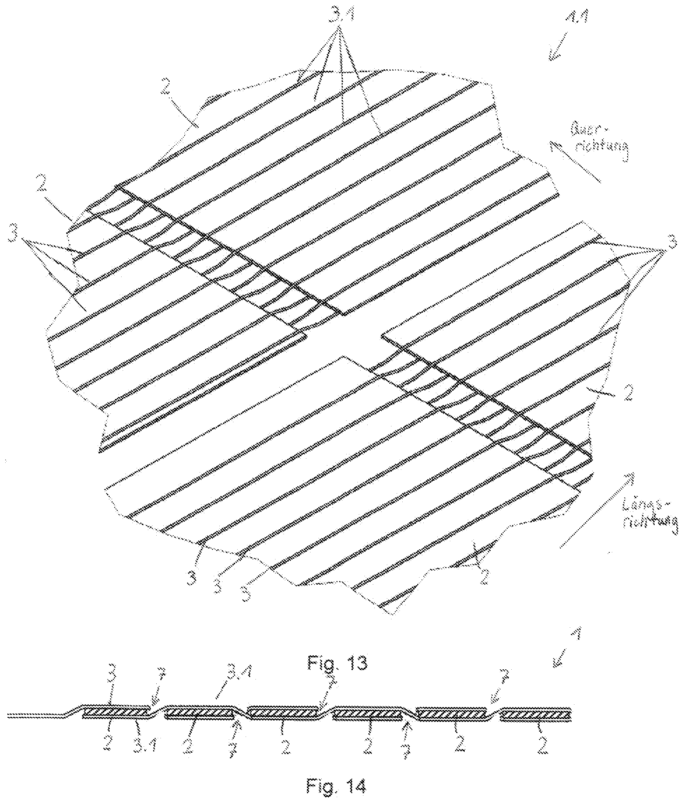

- Fig. 13:: dreidimensionale Ansicht gem. Fig. 11 von oben vergrößert, wobei jedoch keine gedruckten Leiterbahnen verwendet wurden,
- Fig. 14:: Längsschnitt von hintereinander und nebeneinander angeordneten Solarzellen gem. Fig. 11, wobei abwechselnd zwischen hintereinander angeordneten Solarzellen die ersten und die zweiten Drahtleiter getrennt wurden, so dass eine Reihenschaltung entstanden ist,

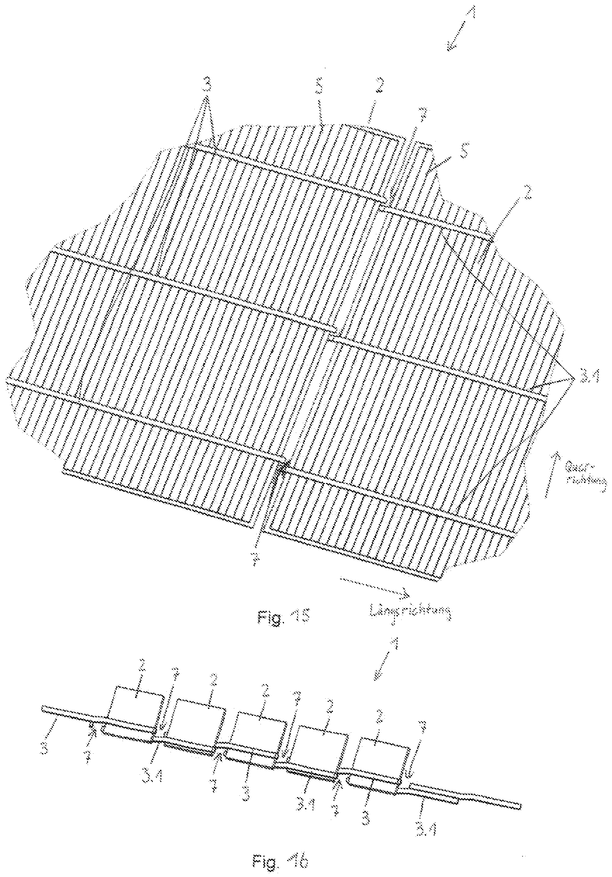

- Fig. 15:: dreidimensionale Ansicht gem. Fig. 14 von oben,
- Fig. 16:: dreidimensionale Ansicht eines Strings nach Variante 3 mit nur einem ersten und einem zweiten Drahtleiter,

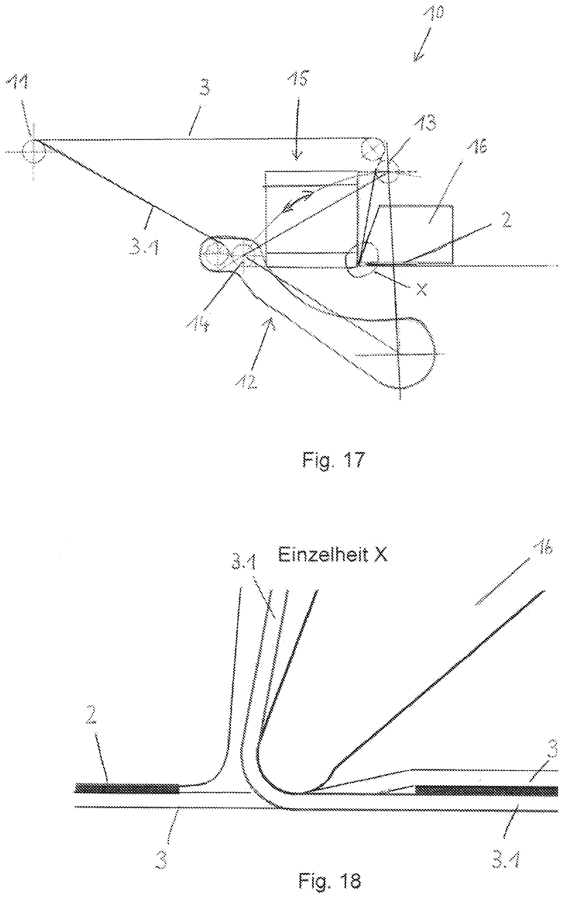

- Fig. 17:: die Darstellung einer Webeinrichtung zur Herstellung eines Solarzellenverbundes nach Variante 3,
- Fig. 18:: Einzelheit X gem. Fig. 17,

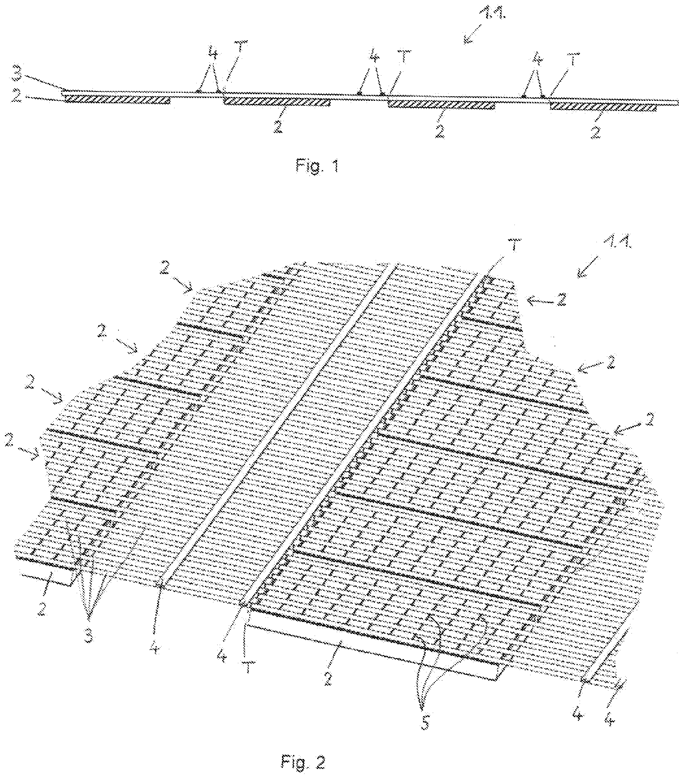

In den Figuren Figur 1 bis 6 sind die Verfahrensstufen zur Herstellung der ersten Variante eines Solarzellenverbundes 1 aus Solarzellen 2 durch die Verwendung erster Drahtleiter 3 und weiterer Kontaktelemente in Form von zu diesen quer verlaufenden Querleitern 4 dargestellt.

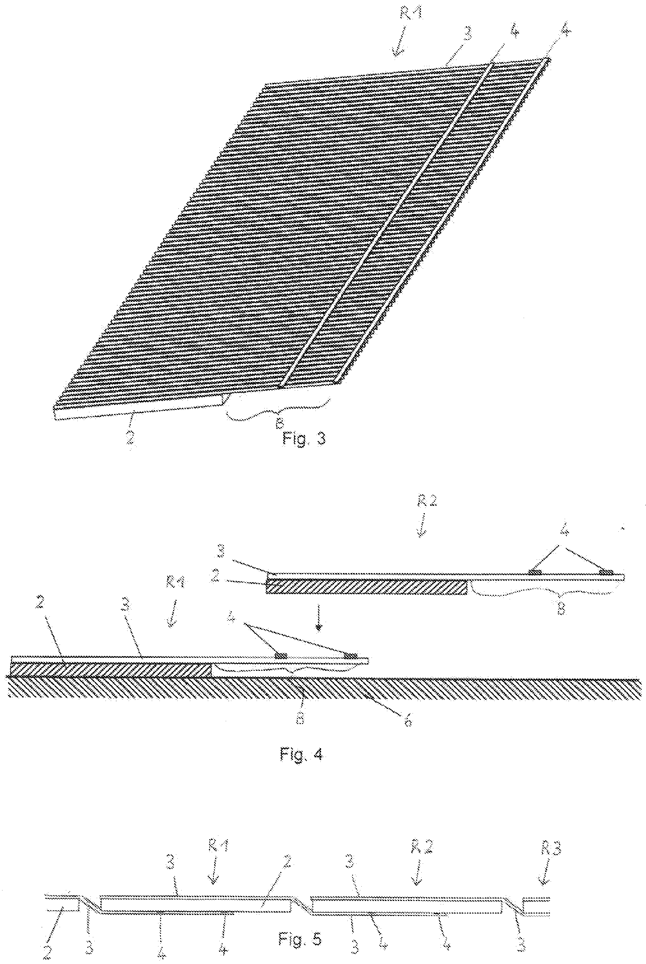

In Fig. 1 und 2 ist eine erste Fertigungsstufe dargestellt, dabei wurden nebeneinander und hintereinander eine Vielzahl von Solarzellen 2 auf eine nicht dargestellte Unterlage aufgelegt. Über den Solarzellen 2 wurden eine Vielzahl erster durchgängiger Drahtleiter 3 in Längsrichtung positioniert und quer zu den ersten Drahtleitern 3 über diesen jeweils zwischen einer Reihe hintereinander angeordneter Solarzellen 2 sowie zu den hintereinander angeordneten Solarzellen beabstandete Querleiter 4 aufgelegt. In den Fig. 1 und 2 ist jeweils unmittelbar vor einer Solarzelle 2 eine Trennlinie T angedeutet. Aus Fig. 2 ist erkennbar, dass auf der Oberfläche der Solarzellen 2 quer zu den ersten Drahtleitern 3 Leiterbahnen 5 aufgedruckt sind. Die zueinander positionierten Solarzellen 2, die ersten Drahtleiter 3 und die Querverbinder 4 werden nun miteinander verbunden und somit kontaktiert und es wird somit ein Zwischenverbund 1.1 hergestellt. Dies erfolgt bevorzugt durch Löten. Anschließend werden die ersten Drahtleiter 3 entlang der Trennlinie T getrennt, so dass mehrere Reihen R1, R2... nebeneinander angeordneter Solarzellen 2 entstehen, die einen überstehenden Bereich B aus ersten Drahtleitern 3 und zwei mit diesen kontaktierten Querleitern 4 aufweist (eine erste Reihe R1 siehe Fig. 3).
Figur 4 zeigt zwei Reihen R1, R2 von Solarzellen 2, die miteinander verbunden werden sollen. Die Reihen R1, R2 werden dazu so positioniert, dass die beiden Querleiter 4 des Bereiches B der ersten Reihe R1 unter der Unterseite der Solarzellen 2 der nachfolgenden Reihe R2 positioniert sind. Die erste Reihe R1 liegt dazu auf einer Montageunterlage 6 auf. Nun wird die zweite Reihe R2 in Pfeilrichtung auf die Montageunterlage 6 und somit auf den Bereich B der ersten Reihe R1 und dadurch auf die Querleiter 4 der ersten Reihe R1 aufgelegt. Dadurch wird der Bereich B der ersten Reihe in Richtung zur Montageunterlage 6 gebogen, was aus der Seitenansicht gem. Fig. 5 ersichtlich ist, in welcher auf diese Weise drei Reihen R1 bis R3 zueinander positioniert sind. Die zueinander positionierten Reihen werden nun miteinander z.B. durch Löten verbunden, so dass die Querleiter 4 an der Unterseite der benachbarten Reihe der Solarzellen 2 kontaktiert sind.

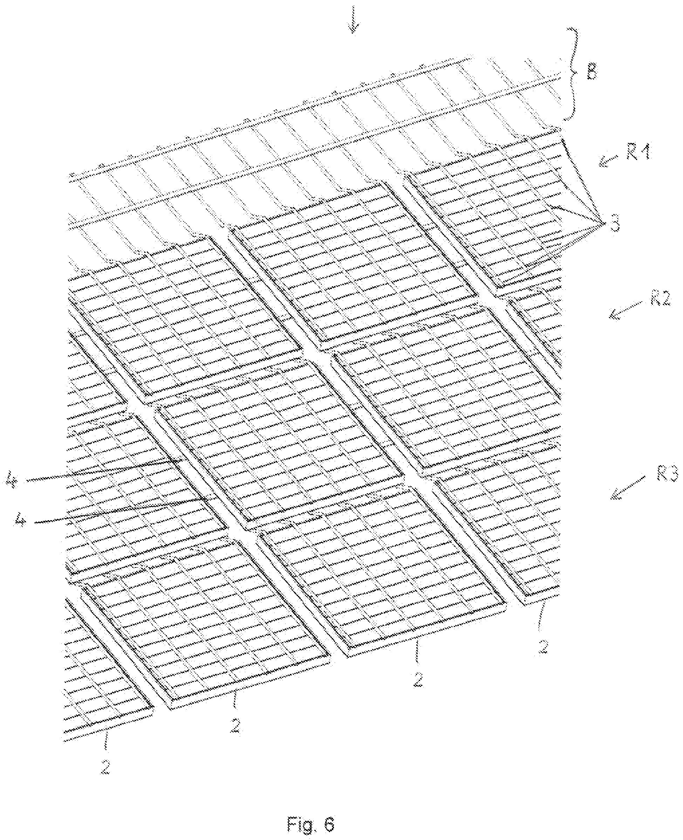

Ein durch dieses erste Verfahren hergestellter Solarzellenverbund 1 in dreidimensionaler Ansicht ist in Fig. 6 dargestellt. Es wurden drei Reihen R1 bis R3 von Solarzellen 2 miteinander verbunden. Über jede Solarzelle 2 führen hier sechs erste Drahtleiter 3 auf die Unterseite der sich in Längsrichtung anschließenden Solarzelle 2. Jeweils zwei Querleiter 4 erstrecken sich über die Solarzellenreihen R1, R2 und sind zwischen den Unterseiten der Solarzellen 2 und den ersten Drahtleitern 2, die auf die Unterseite der Solarzellen reichen, angeordnet (s. Fig. 5).
Gemäß einer nicht dargestellten Verfahrensvariante ist dieser Verbund auch dadurch herstellbar, dass die Querleiter in der ersten Verfahrensstufe nicht über den ersten Drahtleitern kontaktiert werden, sondern gleich an der Unterseite einer Reihe von Solarzellen. Auch in diesem Fall werden die ersten Drahtleiter 3 so getrennt, dass mehrere Reihen entstehen und die überstehenden Bereiche B der Reihen unter den Unterseiten benachbarter Solarzellen der sich anschließenden Reihe positioniert und mit diesen kontaktiert werden.
Die Verfahrensstufen einer zweiten Variante zur Herstellung eines Solarzellenverbundes werden in den Figuren 7 bis 10 gezeigt. Es werden ebenfalls sich längs erstreckende erste Drahtleiter 3 verwendet. Die weiteren Kontaktelemente sind in Form von zu diesen quer verlaufenden Querleitern 4 sowie zu den ersten Drahtleitern 3 parallelen zweiten Drahtleitern 3.1, die auf der Unterseite der Solarzellen 2 verlaufen, ausgebildet.
Der Längsschnitt von hintereinander und nebeneinander angeordneten Solarzellen 2, wobei erste durchgängige Drahtleiter 3 über die Oberseiten der hintereinander angeordneten Solarzellen 2 in Längsrichtung verlaufen und an der Unterseite der Solarzellen 2 zweite durchgängige Drahtleiter 3.1 anliegen und jeweils zwischen den ersten Drahtleitern 3 und den zweiten Drahtleitern 3.1 quer zu diesen und jeweils zwischen den hintereinander angeordneten Solarzellen 2 die Querleiter 4 verlaufen, ist in Fig. 7 dargestellt.
Die dreidimensionale Ansicht von oben gem. Fig. 7 zeigt Fig. 8. Daraus ist erkennbar, dass die in Längsrichtung hintereinander liegenden Solarzellen 2 jeweils mit mehreren durchgängigen ersten Drahtleitern 3 an ihrer Oberseite und mit mehreren dazu parallelen und in Querrichtung versetzten zweiten Drahtleitern 3 an ihrer Unterseite versehen sind. Es ist erkennbar, dass sich rechtwinklig zu den ersten und zweiten Drahtleitern 3, 3.1 die Querleiter 4 zwischen diesen und den Solarzellen 2 in Querrichtung erstrecken. Es werden vorzugsweise zuerst die zweiten Drahtleiter 3.1, dann die Solarzellen 2 und die Querleiter 4 und anschließend die ersten Drahtleiter 3 positioniert und anschließend z.B. im Durchlaufverfahren zu einem Zwischenverbund 1.1 (s. Fig. 7 und 8) verlötet.
Dieser Zwischenverbund 1.1 ist noch nicht funktionsfähig, sondern es muss erst noch die gewünschte Verschaltung durch Trennen der ersten und zweiten Drahtleiter erzeugt werden.
Zur Realisierung einer Reihenschaltung werden bei dem Zwischenverbund 1.1 die ersten und zweiten Drahtleiter 3, 3.1 abwechselnd zum Querleiter 4 unterbrochen. Ein Längsschnitt nach dem Unterbrechen der Verbindung ist in Fig. 9 im Längsschnitt und in Fig. 10 in der dreidimensionalen Ansicht von oben dargestellt. Erst dadurch entsteht der funktionsfähige in Reihe verschaltete Solarzellenverbund gem. Fig. 9 und 10. Es sind darin die durch die Trennung erzeugten Lücken 7 in den ersten und zweiten Drahtleitern 3, 3.1 erkennbar, durch welche abwechselnd die Verbindung zu den Querleitern 4 unterbrochen ist, wodurch eine entsprechende Verschaltung zwischen den Solarzellen 2 und den ersten und zweiten Drahtleitern 3, 3.1 erzeugt wurde.
Ein Längsschnitt einer weiteren Variante wird in Figur 10a gezeigt. Dabei wurden die ersten Drahtleiter 3 (erste Elektrode) und die zweiten Drahtleiter 3.1 (zweite Elektrode) aus unterschiedlichen Werkstoffen gefertigt und ebenfalls als durchgängige Drähte zuerst beidseitig an die Solarzellen angelegt, wobei zwischen den ersten und zweiten Drahtleitern 3. 3.1 und zwischen zwei benachbarten Solarzellen 2 die Querverbinder 4 positioniert wurden und nach der Erzeugung eines elektrischen Kontaktes zwischen der ersten Elektrode (Drahtleiter 3.1) und der Rückseite (hier Unterseite) der Solarzelle 2 sowie der zweiten Elektrode (Drahtleiter 3.1) mit der Vorderseite (hier Oberseite) der Solarzelle 2 die Verbindung der beiden Elektroden (Drahtleiter 3.1, 3.2) realisiert und dann, wie hier dargestellt, die überflüssigen und störenden Drahtbrücken entfernt, so dass anwechselnd zwischen jedem zweiten Drahtleiter 3, 3.1 zum Querverbinder 4 wie eine Lücke 7 entstanden ist, um die (vorher noch kurzgeschlossenen) Zellen in eine elektrisch sinnvolle Schaltung (Parallel- oder Reihenschaltung) zu bringen.

Das Ausschneiden wurde z.B. mittels Laser oder einer nicht zentrierenden oder wie dargestellt einer selbstzentrierenden Schneideinrichtung durchgeführt, die beim Schneiden keine Kräfte auf die Drähte ausübt, wie es in Figur 10b schematisch dargestellt ist.
Die Schneideinrichtung besteht z.B. aus paarweise relativ aufeinander zubewegbaren Messern S, wobei hier mehrere Messerpaare mit Messern S vorgesehen sind, die an ihren Schneidkanten S1 entsprechend der Form der hier dargestellten zu trennenden ersten Drahtleiter 3, welche einen kreisförmigen Querschnitt aufweisen, gekrümmt sind. In diesem Fall weisen die Schneidkanten S1 eine konkave Krümmung auf. Die grau dargestellten ersten Drahtleiter 3 wurden durch die Messer S getrennt.

Bei Drahtleitern mit eckigem (z.B. rechteckigem)Querschnitt werden die Schneidkanten vorzugsweise im Wesentlichen geradlinig ausgeführt (nicht dargestellt).

Es ist möglich, die Schneideinrichtung mittels eines ebenfalls nicht dargestellten Kamerasystems anhand der Zellkanten der Solarzellen zu justieren.

Bei dem Ausführungsbeispiel nach Figur 10c werden zwei Felder F1, F2 im Wesentlichen paralleler erster und zweiter Drahtleiter 3. 3.1 verwendet.
Das hier dargestellte erste Drahtfeld F1 mit unteren zweiten Drahtleitern 3.1 wird über die Gesamtlänge des zu fertigenden Strings bzw. Matrix aus gelegt und in Längsrichtung der ersten Drahtleiter gespannt. Nach jeweils zwei ersten Drahtleitern 3.1, die in einem geringeren Abstand zueinander angeordnet sind ist hier ein größerer Abstand zu den nächsten zwei zweiten Drahtleitern 3.1 vorgesehen.
Anschließend werden die Solarzellen 2 mit ihren Rückseiten über diesem ersten Drahtfeld F1 positioniert (Fig. 10d). Gegebenenfalls kann der Kontakt zwischen Rückseite der Solarzellen 2 und ersten Drahtfeld F1 bereits erzeugt werden.

In die Zellzwischenräume der Solarzellen 2 kann ein Kontaktelement in Form eines Querverbinders 4 gelegt werden (Fig. 10e), um später den Kontakt zwischen ersten und zweiten Drahtfeld F1, F2 zu realisieren. Die Kontaktelemente/Querverbinder 4 haben eine Dicke entsprechen der Zelldicke der Solarzellen 2, dadurch wird kein Druck auf die Zellkante der Solarzelle 2 ausgeübt.

Im nächsten Schritt wird das zweite Drahtfeld F2, welches aus zueinander parallel verlaufenden ersten Drahtleitern 3 gebildet wird, parallel zum ersten Drahtfeld F1 über den Oberseiten der Solarzellen 2 und über den Kontaktelementen/Querverbindern 4 angeordnet und gespannt, wobei das zweite Drahtfeld F2, wie in Figur 10f dargestellt, versetzt zum ersten Drahtfeld F1 angeordnet ist. Die ersten Drahtleiter 3 des zweiten oberen Drahtfeldes F2 sind hier heller als die zweiten Drahtleiter 3.1 des hier unten liegenden ersten Drahtfeldes F1 dargestellt. (Die ersten und zweiten Drahtleiter 3, 3.1 können auch im Wesentlichen fluchtend übereinander liegen - hier nicht dargestellt.) Die elektrische Verbindung zwischen den Drahtfeldern F1, F2, und daher zwischen ersten Drahtleitern 3 und zweiten Drahtleitern 3.1 und der Solarzelle 2, sowie zwischen dem ersten Drahtfeld F1 (zweiten Drahtleitern 3.1) und dem zweiten Drahtfeld F2 (ersten Drahtleitern 3) und Kontaktelement/Querverbinder 4 wird hergestellt. Dabei können verschiedene Technologien genutzt werden.

Abschließend werden gemäß Figur 10g noch überschüssige Verbindungen getrennt, so dass zwischen den hier unter den Solarzellen 2 angeordneten zweiten Drahtleitern 3.1 und den Querverbindern 4 Lücken 7 entstehen, die in der Darstellung auf der linken Seite des Querverbinders 4 liegen, und wobei auch zwischen den oben liegenden ersten Drahtleitern 3 und dem Querverbinder 4 Lücken 7 gebildet werden, die hier auf der rechten Seite des Querverbinders 4 angeordnet sind, um eine entsprechende Verschaltung zu erzeugen.
Der Trennschnitt kann wie vorgenannt beschrieben mechanisch oder mittels Laser erfolgen.

Neben den vorgenannten Ausführungsbeispielen ist es auch möglich, auf der Rückseite der Solarzellen 2 breitere Elektrodenstrukturen zu verwenden. Dies reduziert die Übergangswiderstände für den Stromfluss von Zelle zu Zelle. Auf der Vorderseite würde das verwenden von breiten Elektrodenstrukturen zu einer erhöhten Abschattung führen.

Erfindungsgemäß wird daher in einer weiteren Ausführung gemäß Figur 10h auf der Vorderseite der Solarzellen 2 ein zweites Drahtfeld F2 ais ersten dünnen Drahtleitern 3.1 analog Ausführungsbeispiel gemäß Figur 10c bis 10g verwendet. Dadurch wird ein optimiert niedriger Leistungsverlust durch Verschattung und Widerstand realisiert. Auf der Rückseite der Solarzellen 2 werden zweite Drahtleiter 3.1 in Form von breiteren Kontaktbändchen bis hin zu Bändern verwendet. Auf diese Weise können die Leitungsverluste in der rückseitigen Kontaktstruktur auf ein vernachlässigbares Niveau gesenkt werden. Auch hier werden nach der Kontaktierung der Bauteile zwischen der ersten Drahtleitern 3 (dünne Drähte) und den Querverbindern 4 Bereiche ausgestanzt oder anderweitig getrennt, so dass Lücken 7 entstehen und auch zwischen den zweiten Drahtleitern 3.1 (Metallbänder) und den Querverbindern 4 Bereiche entfernt, so dass ebenfalls Lücken 7 entstehen, wodurch die gewünschte Verschaltung hergestellt wird. Durch die Verwendung der Kontaktbänder reduziert sich der fertigungstechnische Aufwand für das Trennen.

Gemäß eines weiteren Ausführungsbeispiels, welches in Figur 10i dargestellt ist, kann auch der Rückseitenkontakt der Solarzellen 2 aus einer mehrere zweite Drahtleiter 3.1 ersetzenden Metallfolie gebildet werden, die hier ebenfalls mit 3.1 bezeichnet wurde und die z.B. ganzflächig auf die Zellrückseite der Solarzelle 2 gelötet, geklebt oder mit Laser-Schweißpunkten befestigt wird. Eine Seite der Folie 3.1 steht über den Zellrand der Solarzelle 2 über.

Zum Ausgleich der Waferdicke und zur mechanischen Verstärkung kann ein hier nicht dargestelltes Kontaktelement auf den überstehenden Teil der Folie aufgebracht werden oder der überstehende Teil der Folie wird ohne ein zusätzliches Kontaktelement gefalzt. Dies alles kann in einem vorgelagerten Vorfertigungsprozess erfolgen, so dass die Metallfolie wird bereits vor Anordnung zum Zellverbund mit der Rückseite der Solarzellen kontaktiert und somit vorkonvektioniert wird.

Danach werden die vorbereiteten Wafer in String- bzw. Matrixform angeordnet und die dünnen Drähte in Form der ersten Drahtleiter 3 werden wie in den vorangegangenen Beispielen als Drahtfeld F2 über dem String / der Matrix positioniert und mit der Zellvorderseite der Solarzellen und dem überstehenden Teil der Folie 3.1 der Nachbarzelle kontaktiert.
Analog zu den vorgenannten Ausführungsbeispielen werden ebenfalls Lücken 7 erzeugt.

Weiterhin ist es möglich, die Drahtelektroden und die Solarzellen 2 zunächst in einer ersten Arbeitsstation auf einen beweglichen Matrixcarrier M zu positionieren (Figur 10k). Dieser ist idealer Weise aus einem hoch wärmeleitenden Material mit geringer Wärmekapazität, z.B. aus eloxiertem Aluminium. Die Abbildung 10k zeigt von lins nach rechts die Arbeitsschritte a) Start mir leerem Matrixcrrier M, b) Ausziehen der Rückseitendrähte in Form einer Vielzahl von dünnen zweiten Drahtleiter 3.1 (zweite Elektrode), die im Wesentlichen parallel zueinander ausgerichtet sind. c) Platzieren der Zellen 2 über den zweiten Drahtleitern 3.1 und Ausziehen der Querverbinder 4 jeweils zwischen zwei benachbarten Zellen und rechtwinglig zu den zweiten Drahtleitern 3.1 und sowie d) Ausziehen der Vorderseitendrähte in Form einer Vielzahl von ersten Drahtleitern 3 (erste Elektrode) über den Oberseiten der Solarzellen 2 und dadurch hergestellter Matrixcarrier M. Die ersten und die zweiten Drahtleiter 3, 3.1 sind dabei parallel zueinander angeordnet und liegen hier fluchtend übereinander und weisen die gleiche Anzahl auf.
Mit dieser Variante ist es möglich, die im Matrixcarrier M aufgenommene und vorerst nur zueinander lagepositionierte Matrix aus Solarzellen, Drahtleitern und Querverbindern in nur einem Schritt zu kontaktieren.

Bei einer angenommen Schrittzeit von je 5 s für das Ausziehend der Elektroden (Drahtleiter 3, 3.1) und Querverbinder 4 sowie von 1 s je Solarzelle 2 ergibt sich eine Bearbeitungszeit von nur 75 s auf der ersten Arbeitsstation. Zellen, Elektroden und Querverbinder werden durch gegebenenfalls vertikal bewegliche Positionierhilfen fixiert, die Elektroden und Querverbinder durch geeignete Clamp-Vorrichtungen an den Enden gehalten.

Anschließend wird der gem. Fig. 10k, Darstellung d bestückte Matrixcarrier M von der ersten Arbeitsstation auf eine zweite Arbeitsstation transferiert. Diese ist durch eine strukturierte Heizplatte T gekennzeichnet, in welche negative rückseitige Strukturelemente des Matrixcarriers passen, s. Fig. 10L. Durch die Strukturierung von Heizplatte T und Matrixcarrier M kann letzterer unter den Solarzellen sehr dünn und damit besonders gut wärmeleitend - möglicherweise unterstützt durch eine schwarze Eloxalschicht - ausgeführt werden, während die rückseitigen Stege sowohl die nötige mechanische Steifigkeit gewährleisten, als auch die Oberfläche für den Wärmeübergang erhöhen.

Die Heizplatte T wird auf einer Temperatur nahe aber unterhalb der Schmelztemperatur des Lotes temperiert. Nach einer kurzen Aufheizphase werden Die Elektroden mit den Solarzellen sowie den Querverbindern gelötet und dadurch in nur einem Schritt sie Kontaktierung einer Vielzahl von Solarzellen mit ersten und zweiten Drahtleitern und Querverbindern hergestellt. Selbstverständlich können anstelle einer Vielzahl dünner zweiter Drahtleiter auch wenige Metallbänder oder eine Metallfolie als zweite Elektrode eingesetzt werden.

Je nach dafür benötigter Zeit kann auf der zweiten Arbeitsstation bereits das Trennen der Elektroden (Drahtleiter 3, 3.1) erfolgen, z.B. parallel oder zeitversetzt zum Lötprozess. Anschließend wird der Matrixcarrier zu einer nicht dargestellten dritten Arbeitsstation transportiert.

Diese kann mit einer Kühlplatte analog zur zweiten Arbeitsstation ausgeführt sein, um die Abkühlung des Matrixcarrier zu beschleunigen. Auf dieser Arbeitsstation wird - falls nicht auf Station 2 erfolgt - das Trennen der Drahtfelder durchgeführt.

Für den Fall, dass die oben erwähnten Positionierhilfen und Clampvorrichtungen entweder zurückgezogen werden können (z.B. federgelagert in die aussteifenden rückseitigen Strukturelemente des Carriers) oder deutlich außerhalb der Matrix liegen, kann anschließend das Einbettmaterial (z.B. EVA) und die Modulglasplatte auf dem Carrier abgelegt und fixiert werden. Anschließend wird der Carrier mitsamt Matrix, Einbettmaterial und Glas gedreht, die Fixierung des Glases gelöst und der Carrier abgehoben. Zur weiteren Prozessierung wird die Modulglasscheibe auf herkömmliche Weise weiterbearbeitet (z.B. zweite Lage EVA und Rückseitenfolie aufbringen und laminieren). Dadurch wird vermieden die Matrix mittels Greifern, Vakuum-Saugern oder Bernoulli-Greifern transportieren zu müssen.

Ein Vorteil dieser Anordnung ist das parallelisieren der zeitaufwendigen Arbeitsschritte Zellpositionierung und Lötprozess. Dadurch wird auch die Verweilzeit auf der Heizplatte minimiert. Die Zellmatrix wird mitsamt den empfindlichen Lötstellen und dünnen Elektroden stets entweder durch den Matrixcarrier oder im weiteren Verlauf durch die Glasplatte gestützt.
Nach dem Kontaktieren im Matrixcarrier werden je nach Ausführung die ersten und/oder zweiten Drahtleiter zwischen den Solarzellen getrennt, so dass die gewünschte Verschaltung entsteht. Dies erfolgt bevorzugt im Matrixcarrier oder in einer weiteren Vorrichtung mit einer entsprechenden Schneid/Trenneinrichtung.

Im Unterschied zu den vorgenannten Ausführungsbeispielen, bei welchen Querverbinder verwendet wurden, ist es auch möglich, die ersten und zweiten Drahtleiter 3, 3.1 direkt miteinander in Verbindung zu bringen und zu kontaktieren, dies erfolgt mechanisch dadurch, dass die Drahtleiter 3, 3.1 zueinander geführt, z.B. gebogen und miteinander verbunden werden durch z.B. verquetschen oder Löten. Dies erfolgt bevorzugt im noch gespannten Zustand der Drahtleiter 3, 3.1.Es ist jedoch auch möglich, die direkte Verbindung zwischen den ersten und zweiten Drahtleitern nach deren Trennen für eine entsprechende Verschaltung zu erzeugen. Figur 10M zeigt ein Ausführungsbeispiel, bei welchem die ersten und zweiten Drahtleiter 3, 3.1, die beidseitig zur Solarzelle 2 angeordnet sind, direkt miteinander verbunden und mit entsprechende Lücken 7 durch Trennung der Drahtleiter versehen wurden.

Diese Variante hat den Vorteil, dass die Querverbinder eingespart werden können.

In den Figuren 11 bis 18 sind die Verfahrensstufen und eine Einrichtung zur Herstellung einer weiteren Variante eines Solarzellenverbundes 1 aus Solarzellen 2 durch die Verwendung erster Drahtleiter 3, die alternierend zwischen der Oberseite und der Unterseite der Solarzellen 2 verlaufen und weiterer Kontaktelemente in Form von zu den ersten Drahtleitern 3 parallelen zweiten Drahtleitern 3.1, die umgekehrt alternierend zu den ersten Drahtleitern 3 zwischen den Unterseiten und den Oberseiten der Solarzellen 3 verlaufen, dargestellt.
Den Längsschnitt eines Zwischenverbundes von hintereinander und nebeneinander angeordneten Solarzellen 2, wobei ein durchgängiger erste Drahtleiter 3 über die Oberseite und die Unterseite der benachbarten Solarzellen 3 läuft und der durchgängige zweite Drahtleiter 3.1 dazu umgekehrt zwischen der Unterseite und der Oberseite der benachbarten Solarzellen 2 verläuft, ist in Fig. 11 und die dreidimensionale Ansicht gem. Fig. 11 von oben in Fig. 12 dargestellt. Die Solarzellen sind an ihrer Oberseite mit Leiterbahnen 5 versehen, die quer zu den ersten und zweiten Drahtleitern aufgedruckt sind. In Fig. 13 ist ein Zwischenverbund 1.1 dargestellt, bei welchem keine Leiterbahnen aufgedruckt sind, wodurch der Fertigungsaufwand verringert und Kosten erheblich reduziert werden.
Nachdem die Solarzellen mit den ersten und zweiten Drahtleitern ein Zwischenverbund 1.1 kombiniert und durch Löten kontaktiert wurden, ist es wie bei Variante 2 erforderlich, die Drahtleiter entsprechend der gewünschten Verschaltung zu trennen, so dass der gewünschte Solarzellenverbund entsteht.
Fig. 14 zeigt Längsschnitt und Fig. 15 die dreidimensionale Ansicht von hintereinander und nebeneinander angeordneten Solarzellen 2, wobei abwechselnd zwischen hintereinander angeordneten Solarzellen 2 die ersten und die zweiten Drahtleiter 3. 3.1 getrennt wurden, so dass durch die beim Trennen (bevorzugt mittels Laser) entstehenden Lücken 7 eine Reihenschaltung gebildet wird und der gewünschte Solarzellenverbund 1 entsteht.
In Figur 16 ist die dreidimensionale Ansicht eines nach Variante 3 hergestellten Strings S mit Solarzellen 2, die mit nur einem ersten und einem zweiten Drahtleiter 3, 3.1 kontaktiert wurden, dargestellt. Auch hier sind durch das Trennen der Drahtleiter 3, 3.1 Lücken 7 vorhanden und es wurde dadurch eine Reihenschaltung realisiert.
In Fig. 17 wird die Prinzipdarstellung einer Vorrichtung 10 zur Herstellung eines Solarzellenverbundes bzw. eines Zwischenverbundes nach Variante 3 dargestellt und die Einzelheit gem. Fig. 17 zeigt Fig. 18. Über eine erste Rollenzuführung werden eine Vielzahl nebeneinander liegender erste Drahtleiter 3 und eine Vielzahl dazwischen liegender zweiter Drahtleiter 3.1 der Webeinrichtung 12 zugeführt. Die Drahtleiter 3, 3.1 werden mittels Webrollen13, 14 alternierend entsprechend des Pfeils nach oben und unten bewegt. Jeweils dazwischen wird mittels eines Zellenhandlings 15 eine Reihe mehrerer Solarzellen 2 eingelegt und dann in Transportrichtung bewegt und anschließend die ersten und zweiten Drahtleiter 3, 3.1 umgespannt. Zur Vermeidung des Bruchs der Solarzellen ist ein Niederhalter 16 vorgesehen, der die Drahtleiter 3, 3.1 in der Ersteckungsebene der Solarzellen 2 beim Webvorgang hält.
Es ist mit allen drei Varianten möglich, einen Solarzellenverbund herzustellen, der einen kompletten Solarzellenmodul bildet oder der eine Vielzahl von Solarzellenmodulen aufweist und dann in einzelne Module getrennt wird.

Mit der erfindungsgemäßen Lösung wird die Herstellung von Solarzellenmodulen revolutioniert.

## Patentansprüche

1. Verfahren zum Kontaktieren und Verschalten von Solarzellen (2) mittels mindestens zweier unabhängiger Elektroden, wobei mindestens eine Elektrode aus wenigstens einem Drahtleiter (3) gebildet wird mit folgenden Schritten:
- Positionieren eines durchgängigen Drahtleiters (3), so dass er sich über mehrere Solarzellen (2) erstreckt,
- Unterbrechen der Elektroden an den für das Verschalten erforderlichen Positionen nachdem sich der Drahtleiter (3) über mehrere Solarzellen erstreckt und bevor die Solarzellen (2) unter einer Glasplatte fixiert werden,
- Kontaktieren der Solarzellen (2) und Elektroden, wobei die Elektroden durch Querverbinder (4) miteinander kontaktiert werden, wobei die Anordnung des Querverbinders (4) im Wesentlichen senkrecht zur Ausrichtung der Drahtleiter (3) der ersten Elektrode und im Zwischenraum zwischen zwei benachbarten Solarzellen (2) sowie zwischen erster und zweiter Elektrode ist,
- Kontaktieren der Elektroden mit den Solarzellen (2) und/oder Kontaktieren der mindestens zwei Elektroden untereinander vor dem Unterbrechen der Elektroden.

2. Verfahren nach Anspruch 1, **dadurch gekennzeichnet, dass** es mit folgenden Schritten durchgeführt wird:
- Anordnen einer ersten Elektrode auf der Lichteinfallsseite mehrerer Solarzellen (2), wobei die erste Elektrode aus einer Vielzahl von zueinander im Wesentlichen parallelen Drahtleitern (3) gebildet wird, die sich über mindestens zwei benachbarte Solarzellen (2) erstrecken,
- Kontaktieren der Drahtleiter (3) der ersten Elektrode mit einer zweiten Elektrode auf der Rückseite der benachbarten Solarzelle (2),
- Unterbrechen der Drahtleiter (3) der ersten Elektrode und/oder der zweiten Elektrode zwischen der Kontaktstelle der ersten und zweiten Elektrode und dem Rand der benachbarten Solarzelle (2).

3. Verfahren nach einem der Ansprüche 1 und 2, **dadurch gekennzeichnet**, **dadurch gekennzeichnet, dass** der/die ersten Drahtleiter (3) der ersten Elektrode auf der Oberseite (Lichteinfallseite) der Solarzellen (2) kontaktiert werden und dass die weiteren Kontaktelemente in Form von zweiten Drahtleitern (3.1) der zweiten Elektrode und in Form von Querverbindern (4) ausgebildet sind, wobei die zweiten Drahtleiter (3.1) im Wesentlichen parallel zu den ersten Drahtleitern (3) auf der Unterseite der Solarzellen (2) kontaktiert werden und die ersten und die zweiten Drahtleiter (3, 3.1) durch die elektrischen Querverbinder (4) miteinander verschaltet werden.

4. Verfahren nach Anspruch 3, **dadurch gekennzeichnet, dass** jeweils abwechselnd die Verbindung des ersten Drahtleiters (3) und des zweiten Drahtleiters (3.1) zum Querverbinder (4) unterbrochen wird, so dass eine Reihenschaltung entsteht.

5. Verfahren nach einem der Ansprüche 1 bis 4, **dadurch gekennzeichnet, dass** das Herstellen der Kontaktierung unter Verzicht des Aufdruckens von Bars auf die Solarzelle (2) erfolgt.

6. Solarzellenverbund bei welchem die Solarzellen (2) mittels mindestens zweier unabhängiger Elektroden miteinander kontaktiert sind, wobei eine erste Elektrode mehrere Solarzellen zuerst überspannt, wobei die erste Elektrode eine Vielzahl von zueinander im Wesentlichen parallelen ersten Drahtleitern (3) aufweist, die mit einer Lichteinfallsseite dieser Solarzellen (2) kontaktiert sind und wobei eine zweite Elektrode mehrere Solarzellen zuerst überspannt, wobei die zweite Elektrode eine Vielzahl von zueinander im Wesentlichen parallelen zweiten Drahtleitern (3.1) aufweist, die mit der Rückseite dieser Solarzellen (2) kontaktiert sind und wobei die erste und die zweite Elektrode zwischen zwei Solarzellen (2) durch Querverbinder (4) miteinander kontaktiert sind und die erste und zweite Elektrode an den zur Verschaltung erforderlichen Positionen zwischen den Solarzellen (2) getrennt sind.

7. Solarzellenverbund nach Anspruch 6, **dadurch gekennzeichnet, dass** er mehrere untereinander verbundene und kontaktierte Solarzellen (2) aufweist, wobei die Solarzellen (2) mit wenigstens einem in Längsrichtung von aneinandergereihten Solarzellen (2) (durchgängig) verlaufenden ersten Drahtleiter (3) der ersten Elektrode oder einer Gruppe von ersten Drahtleitern (3) der ersten Elektrode und mit wenigstens einem weiteren Kontaktelement oder einer Gruppe von weiteren Kontaktelementen miteinander zu einem Solarzellenverbund (1) verbunden und kontaktiert sind und dass vor oder nach dem Herstellen der elektrischen Verbindung die ersten Drahtleiter (3) und/oder die weiteren Kontaktelemente (zwischen den Solarzellen) so getrennt sind, dass eine Reihenschaltung oder eine Parallelschaltung vorhanden ist.

8. Solarzellenverbund nach Anspruch 7, **dadurch gekennzeichnet, dass** mehrere durch das Trennen gebildete streifenartige Solarzellenverbunde (1) wieder so miteinander verbunden und kontaktiert sind dass der/die ersten Drahtleiter (3) jeweils von der Oberseite einer Solarzelle (2) zur Unterseite der benachbarten Solarzellen (2) verläuft/verlaufen und dass die weiteren Kontaktelemente in Form von Querverbindern (4) ausgebildet sind, die zwischen der Unterseite der Solarzelle (2) und dem ersten Drahtleiter (3) angeordnet sind und mit der/den Solarzelle/n (2) und dem/den ersten Drahtleiter/n (3) kontaktiert sind, wobei der/die ersten Drahtleiter (3) jeweils auf der Oberseite einer Solarzelle (2) kontaktiert sind und dass die weiteren Kontaktelemente in Form von zweiten Drahtleitern (3.1) und in Form von Querverbindern (4) ausgebildet sind, wobei die zweiten Drahtleiter (3.1) im Wesentlichen parallel zu den ersten Drahtleitern (3) an der Unterseite der Solarzellen (2) kontaktiert sind und dass sich quer zu den ersten und zweiten Drahtleitern (3, 3.1) wenigstens ein mit diesen in Reihenschaltung kontaktierter Querverbinder (4) erstreckt.

9. Solarzellenverbund nach einem der Ansprüche 6 bis 8, **dadurch gekennzeichnet, dass** die ersten und/oder zweiten Drahtleiter (3, 3.1) und/oder die Querverbinder (4) unter Verzicht des Aufdruckens von Bars (Leiterbahnen) direkt mit der/den Solarzelle/n (2) verbunden sind.

10. Solarzellenverbund nach einem der Ansprüche 6 bis 9, **dadurch gekennzeichnet, dass** das Kontaktelement/der Querverbinder (4), der zwischen zwei Solarzellen (2) angeordnet ist im Wesentlichen eine gleich große oder größere Dicke als die Solarzellen (2) aufweist.

## Claims

1. A method for contacting and interconnecting solar cells (2) by means of at least two independent electrodes, wherein at least one electrode is formed from at least one wire conductor (3), comprising the following steps:
- positioning a continuous wire conductor (3) so that it extends over a plurality of solar cells (2),
- interrupting the electrodes at the positions required for the interconnection once the wire conductor (3) extends over several solar cells and before the solar cells (2) are fixed under a glass plate,
- contacting the solar cells (2) and electrodes, wherein the electrodes contact each other by cross-connectors (4), wherein the arrangement of the cross-connector (4) is essentially perpendicularly to the orientation of the wire conductors (3) of the first electrode and in the intermediate space between two adjoining solar cells (2), as well as between first and second electrode,
- contacting the electrodes with the solar cells (2) and/or contacting the at least two electrodes with one another before the electrodes are interrupted.

2. A method according to claim 1, **characterized in that** it is carried out with the following steps:
- arranging a first electrode on the light incident side of a plurality of solar cells (2), wherein the first electrode is formed from a plurality of mutually substantially parallel wire conductors (3) extending over at least two adjacent solar cells (2),
- contacting the wire conductors (3) of the first electrode with a second electrode on the rear side of the adjacent solar cell (2),
- interrupting the wire conductor (3) of the first electrode and/or the second electrode between the contact point of the first and second electrode and the edge of the adjacent solar cell (2).

3. A method according to one of the claims 1 and 2, **characterized in that** the first wire conductor(s) (3) of the first electrode is/are contacted on the upper side (light incident side) of the solar cells (2), and that the further contact elements are designed in form of second wire conductors (3.1) of the second electrode and in form of cross-connectors (4), wherein the second wire conductors (3.1) are contacted essentially parallel to the first wire conductors (3) on the underside of the solar cells (2), and the first and second wire conductors (3, 3.1) are interconnected to each other by the electrical cross-connectors (4).

4. A method according to claim 3, **characterized in that** in a respective alternating manner the connection of the first wire conductor (3) and the second wire conductor (3.1) to the cross-connector (4) is interrupted so that a series circuit is produced.

5. A method according to one of the claims 1 to 4, **characterized in that** the establishing of the contacting is carried out without the printing of bars on the solar cell (2).

6. A solar cell assembly, in which the solar cells (2) are in contact with each other by means of at least two independent electrodes, wherein a first electrode traverses several solar cells at first, wherein the first electrode has a plurality of mutually substantially parallel first wire conductors (3) which are contacted to a light incident side of these solar cells, and wherein a second electrode traverses several solar cells at first, wherein the second electrode comprises a plurality of mutually substantially parallel second wire conductors (3.1), which are contacted to the rear side of these solar cells (2), and wherein the first and second electrode are contacted to one another between two solar cells (2) by cross-connectors (4), and the first and second electrodes are disconnected between the solar cells (2) at the positions required for interconnection.

7. The solar cell assembly according to claim 6, **characterized in that** it comprises several solar cells (2) contacted and interconnected to each other, wherein solar cells (2) are connected and contacted to each other to form a solar cell assembly (1) with at least first wire conductor (3) of the first electrode extending (continuously) in the longitudinal direction of staggered solar cells (2) or a group of first wire conductors (3) of the first electrode and with at least one further contact element or a group of further contact elements, and that before or after the production of the electrical connection the first wire conductors (3) and/or the further contact elements (between the solar cells) are disconnected in such a way that a series connection or a parallel connection is present.

8. A solar cell assembly according to claim 7, **characterized in that** a plurality of strip-like solar cell assemblies (1) formed by the disconnection are again connected and contacted to one another in such a way that the first wire conductor(s) (3) extend(s) from the respective upper side of a solar cell (2) to the underside of the adjoining solar cells (2), and that the further contact elements are designed in the form of cross-connectors (4) which are arranged between the underside of the solar cell (2) and the first wire conductor (3) and are contacted to the solar cell(s) (2) and the first wire conductor(s) (3), wherein the first wire conductor(s) (3) is/are respectively contacted on the upper side of a solar cell (2), and that the further contact elements are arranged in the form of second wire conductors (3.1) and in the form of cross-connectors (4), wherein the second wire conductors (3.1) are contacted substantially parallel to the first wire conductors (3) on the underside of the solar cells (2), and that transversely to the first and second wire conductors (3, 3.1) at least one cross-connector (4) extends which is contact therewith in a series circuit.

9. A solar cell assembly according to one of the claims 6 to 8, **characterized in that** the first and/or second wire conductors (3, 3.1) and/or the cross-connectors (4) are connected directly to the solar cell(s) (2) without the printing of bars (conductor tracks).

10. A solar cell assembly according to one of the claims 6 to 9, **characterized in that** the contact element/the cross-connector (4), which is arranged between two solar cells (2), has essentially the same or a greater thickness than the solar cells (2).

## Revendications

1. Procédé pour la mise en contact et la connexion de cellules solaires (2) au moyen d'au moins deux électrodes indépendantes, dans lequel au moins une électrode est formée par au moins un fil conducteur (3), comprenant les étapes suivantes :
- positionnement d'un fil conducteur (3) continu de telle manière qu'il s'étende sur plusieurs cellules solaires (2),
- interruption des électrodes dans les positions nécessaires pour la connexion après que le fil conducteur (3) a été étendu sur cellules solaires et avant que les cellules solaires (2) soient fixées sous une plaque de verre,
- mise en contact des cellules solaires (2) et des électrodes, lesquelles électrodes sont mises en contact les unes avec les autres par des connecteurs transversaux (4), la disposition du connecteur transversal (4) étant sensiblement perpendiculaire à l'orientation du fil conducteur (3) de la première électrode et se trouvant dans l'espace compris entre deux cellules solaires (2) voisines et entre la première électrode et la deuxième,
- mise en contact des électrodes avec les cellules solaires (2) et/ou mise en contact des au moins deux électrodes entre elles avant l'interruption des électrodes.

2. Procédé selon la revendication 1, **caractérisé en ce qu'**il est mis en oeuvre selon les étapes suivantes :
- disposition d'une première électrode sur le côté d'entrée de la lumière de plusieurs cellules solaires (2), la première électrode étant formée d'un grand nombre de fils conducteurs (3) sensiblement parallèles entre eux, qui s'étendent sur au moins deux cellules solaires (2) voisines,
- mise en contact des fils conducteurs (3) de la première électrode avec une deuxième électrode sur la face arrière de la cellule solaire (2) voisine,
- interruption des fil conducteur (3) de la première électrode et/ou de la deuxième électrode entre le point de contact des première et deuxième électrodes et le bord de la cellule solaire (2) voisine.

3. Procédé selon l'une des revendications 1 et 2, **caractérisé en ce que** le ou les premiers fils conducteurs (3) de la première électrode sont mis en contact sur la face supérieure (face d'entrée de la lumière) des cellules solaires (2) et **en ce que** les autres éléments de contact sont conformés comme des deuxièmes fils conducteurs (3.1) de la deuxième électrode et comme des connecteurs transversaux (4), les deuxièmes fils conducteurs (3.1) étant mis en contact de façon sensiblement parallèle aux premiers fils conducteurs (3) sur la face inférieure des cellules solaires (2) et les premiers et deuxièmes fils conducteurs (3, 3.1) étant connectés les uns aux autres par les connecteurs électriques transversaux (4).

4. Procédé selon la revendication 3, **caractérisé en ce que** la liaison du premier fil conducteur (3) et du deuxième fil conducteur (3.1) au connecteur transversal (4) est interrompue alternativement, de sorte qu'il se crée un circuit en série.

5. Procédé selon l'une des revendications 1 à 4, **caractérisé en ce que** les contacts sont fabriqués sans impression de barres sur la cellule solaire (2).

6. Assemblage de cellules solaires dans lequel les cellules solaires (2) sont mises en contact au moyen d'au moins deux électrodes indépendantes, une première électrode s'étendant à plusieurs cellules solaires, la première électrode présentant un grand nombre de premiers fils conducteurs (3) sensiblement parallèles qui sont mis en contact avec un côté d'entrée de la lumière de ces cellules solaires (2) et une deuxième électrode s'étendant d'abord à plusieurs cellules solaires, la deuxième électrode présentant un grand nombre de deuxièmes fils conducteurs (3.1) sensiblement parallèles qui sont mis en contact avec la face arrière de ces cellules solaires (2) et les première et deuxième électrodes étant mises en contact l'une avec l'autre entre deux cellules solaires (2) par des connecteurs transversaux (4) et les première et deuxième électrodes étant séparées dans les positions nécessaires à la connexion entre les cellules solaires (2).

7. Assemblage de cellules solaires selon la revendication 6, **caractérisé en ce qu'**il comprend plusieurs cellules solaires (2) reliées et mises en contact entre elles, les cellules solaires (2) étant reliées et mises en contact par au moins un premier fil conducteur (3) de la première électrode ou un groupe de fils conducteurs (3) de la première électrode qui s'étend (de façon continue) dans le sens de la longueur de cellules solaires (2) alignées les unes avec les autres et par au moins un autre élément de contact ou un groupe d'autres éléments de contact pour former un assemblage de cellules solaires (1) et **en ce qu'**avant ou après l'établissement de la liaison électrique, les premiers fils conducteurs (3) et/ou les autres éléments de contact (entre les cellules solaires) sont séparés de telle sorte qu'il se crée un montage en série ou un montage en parallèle.

8. Assemblage de cellules solaires selon la revendication 7, **caractérisé en ce que** plusieurs assemblages de cellules solaires (1) en forme de bandes formés par la séparation sont à nouveau reliés et mis en contact entre eux, **en ce que** le ou les premiers fils conducteurs (3) vont chacun de la face supérieure d'une cellule solaire (2) à la face inférieure des cellules solaires (2) voisines et **en ce que** les autres éléments de contact sont conformés comme des connecteurs transversaux (4) qui sont disposés entre la face inférieure de la cellule solaire (2) et le premier fil conducteur (3) et sont mis en contact avec la ou les cellules solaires (2) et le ou les premiers fils conducteurs (3), le ou les premiers fils conducteurs (3) étant mis en contact chacun sur la face supérieure d'une cellule solaire (2), et **en ce que** les autres éléments de contact sont conformés comme des deuxièmes fils conducteurs (3.1) et comme des connecteurs transversaux (4), les deuxièmes fils conducteurs (3.1) étant mis en contact de façon sensiblement parallèle aux premiers fils conducteurs (3) sur la face inférieure des cellules solaires (2), et **en ce qu'**au moins un connecteur transversal (4) mis en contact avec les premiers et deuxièmes fils conducteurs (3, 3.1) dans un montage en série s'étend transversalement par rapport à ceux-ci.

9. Assemblage de cellules solaires selon l'une des revendications 6 à 8, **caractérisé en ce que** les premiers et/ou deuxièmes fils conducteurs (3, 3.1) et/ou les connecteurs transversaux (4) sont reliés directement à la ou aux cellules solaires (2) sans impression de barres (pistes conductrices).

10. Assemblage de cellules solaires selon l'une des revendications 6 à 9, **caractérisé en ce que** l'élément de contact ou le connecteur transversal (4) disposé entre deux cellules solaires (2) présente pour l'essentiel une épaisseur égale ou supérieure à celle des cellules solaires (2).
